(19) Europäisches Patentamt
European Patent Office
Office européen des brevets

(11) **EP 2 028 292 B1**

(12) **EUROPÄISCHE PATENTSCHRIFT**

(45) Veröffentlichungstag und Bekanntmachung des Hinweises auf die Patenterteilung:
**17.12.2014 Patentblatt 2014/51**

(51) Int Cl.:
*C30B 11/14* *(2006.01)*     *C30B 29/06* *(2006.01)*

(21) Anmeldenummer: **08161248.3**

(22) Anmeldetag: **28.07.2008**

(54) **Verfahren zur Herstellung von monokristallinen Metall- oder Halbmetallkörpern**

Method for manufacturing monocrystalline metal or semi-metal bodies

Procédé de fabrication de corps métallique ou semi-métalliques monocristallins

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **16.08.2007 DE 102007038851**

(43) Veröffentlichungstag der Anmeldung:
**25.02.2009 Patentblatt 2009/09**

(73) Patentinhaber: **Fraunhofer-Gesellschaft zur Förderung der angewandten Forschung e.V. 80686 München (DE)**

(72) Erfinder:
• **Müller, Matthias**
  **07749 Jena (DE)**
• **Dr. Sahr, Uwe**
  **90411 Nürnberg (DE)**

(56) Entgegenhaltungen:
WO-A-2007/084934      DE-A1-102004 003 035
DE-A1-102006 017 621      DE-A1-102006 017 622
FR-A- 2 567 922      JP-A- 10 007 493
US-A- 3 721 800

EP 2 028 292 B1

## Beschreibung

### Gebiet der Erfindung

Die vorliegende Erfindung betrifft allgemein die Herstellung von vergleichsweise großen monokristallinen Materialrohlingen nach dem Vertical-Gradient-Freeze-Verfahren (nachfolgend auch VGF-Verfahren genannt), insbesondere von monokristallinen Metall- oder Halbmetallkörpern, bevorzugt von monokristallinem Silizium für Anwendungen in der Photovoltaik oder von einkristallinen Germaniumkristallen.

### Hintergrund der Erfindung

Solarzellen sollen einen möglichst hohen Wirkungsgrad bei der Umwandlung von Solarstrahlung in Strom aufweisen. Dieser ist von mehreren Faktoren abhängig, wie unter anderem von der Reinheit des Ausgangsmaterials, dem Eindringen von Verunreinigungen während der Kristallisation von den Berührungsflächen des Kristalls mit dem Tiegel in das Kristallinnere, dem Eindringen von Sauerstoff und Kohlenstoff aus der umgebenden Atmosphäre in das Kristallinnere und auch von der Wachstumsrichtung der einzelnen Kristallkörner.

Aus dem Stand der Technik ist die Herstellung von monokristallinem Silizium nach dem Czochralski-Verfahren bekannt. Damit lässt sich monokristallines Silizium mit niedriger Versetzungsdichte und einer definierten Orientierung herstellen. Damit hergestellte Solarzellen zeichnen sich durch einen hohen Wirkungsgrad aus. Allerdings ist dieses Verfahren sowohl unter energetischen als auch unter herstellungstechnischen Aspekten relativ aufwändig. So hergestellt können nur runde Kristalle werden, was einen sehr hohen Schnittverlust bei der Herstellung der üblicherweise rechtförmigen oder quadratischen Solarzellen bedingt. Sobald bei dem Verfahren ein Versetzungsfehler entsteht, multipliziert sich dieser aufgrund der beim Verfahren vorherrschenden hohen Temperaturgradienten sehr stark, sodass das Material auch für die Photovoltaik im Vergleich zu multikristallinem Silizium kaum Vorteile aufweist.

Aus dem Stand der Technik sind auch verschiedene Varianten der Herstellung von großvolumigen multikristallinen Silizium-Ingots durch gerichtetes Erstarren von schmelzflüssigem Silizium in einem Schmelztiegel bekannt. Diesen bekannten Herstellungsverfahren ist gemeinsam, dass der Kristallschmelze an ihrem Boden Wärme entzogen wird und so ein Kristall von unten nach oben wächst. Aufgrund der typischerweise schnell verlaufenden Erstarrung und des Verzichts auf einen Keimkristall wächst der Kristall nicht als Einkristall sondern multikristallin. Es entsteht ein Block, der aus vielen Kristallkörnern besteht, von denen ein jedes Korn in der Richtung des lokal existierenden Temperaturgradienten wächst.

Wenn nun im schmelzflüssigen Silizium-Volumen die Isothermen des Temperaturfeldes nicht eben und nicht parallel zur Grundfläche des Tiegel, d.h. horizontal, verlaufen, wird sich keine ebene Phasengrenze ausbilden und werden die einzelnen Körner nicht parallel zueinander und senkrecht von unten nach oben wachsen. Dies geht einher mit der Ausbildung linienartiger Kristallbaufehler auch innerhalb der einkristallinen Bereiche. Diese unerwünschten Kristallbaufehler können durch Anätzen polierter Flächen (z.B. an Siliziumwafern) als Ätzgruben sichtbar gemacht werden. Eine wie vorstehend beschrieben erhöhte Anzahl von linienartigen Kristallbaufehlern führt somit zu einer erhöhten Ätzgrubendichte.

Es ist eine bereits lange bekannte Anforderung, die von mehreren Faktoren beeinflussbare Ätzgrubendichte unter anderem durch Einstellung einer ebenen Phasengrenze zu minimieren. Die Ätzgrubendichte ist daher auch ein Maß dafür, wie gut es gelungen ist, durch die ebene Phasengrenze ein säulenartiges Wachstum der Si-Körner zu gewährleisten. Seit Etablierung des HEM-Verfahrens (Heat-Exchange-Method) zu einem ersten für eine Massenproduktion tauglichen Verfahren wird versucht, den Nachteil einer nahezu punktförmigen Wärmesenke am Tiegelboden (wie z.B. aus der US 4,256,530 zu entnehmen) zu vermeiden und im schmelzflüssigen Silizium einen senkrechten Wärmefluss von oben nach unten zu realisieren.

Es gibt daher verschiedene Lösungen, die als einen ersten Schritt darauf abzielen, eine Wärmesenke zu schaffen, die sich über die gesamte Fläche des Tiegelbodens erstreckt (vgl. beispielsweise EP 0 631 832, EP 0 996 516, DE 198 55 061). Die vorliegende Erfindung geht davon aus, dass eine solche flächige Wärmesenke vorgesehen ist.

EP 0 218 088 A1 offenbart eine Vorrichtung zur Herstellung von kolumnar erstarrten Metallschmelzen durch Eingießen einer Metallschmelze in eine Kokille mit nachfolgender Erstarrung in einem gerichteten Temperaturfeld. Die Kokille ist dabei von einem Mantelheizer mit mäanderförmigem Leitungsbahnverlauf umgeben. Die Umkehrbereiche der horizontal verlaufenden einzelnen Leitungsbahnen sind auswärts von der Kokille weggebogen. Allerdings muss der durch die Verbindungsstellen zwischen einzelnen Grafitplatten des Mantelheizers verursachte Widerstand durch eine entsprechende Querschnittsvergrößerung kompensiert werden, was aufwändig ist und nicht präzise erfolgen kann.

EP 1 162 290 A1 offenbart ein Verfahren und eine Vorrichtung zum gerichteten Erstarren einer Metall- oder Halbmetallschmelze in einer Kokille, unter deren Boden zur Zufuhr von Schmelzwärme und zur Abfuhr der Erstarrungswärme bei der gerichteten Erstarrung eine Kühleinrichtung angeordnet ist. Während der Schmelzperiode wird bei eingeschalteter Bodenheizeinrichtung zwischen dieser und der Kühleinrichtung ein Isolierschieber in waagerechter Richtung eingebracht, durch den eine Sichtverbindung zwischen der Bodenheizeinrichtung und der Kühleinrichtung unterbrochen wird. Während der anschließenden Erstarrungsphase wird der Isolierschieber zumindest teilweise in waagerechter Richtung entfernt. Mit diesem Verfahren können nur multikristalline Halbmetall- oder Metallkörper hergestellt werden, die eine vergleichsweise große Versetzungsdichte aufweisen.

DE 198 55 061 offenbart einen entsprechenden Schmelzofen zur Herstellung von multikristallinem Silizium.

Die Deutsche Patentanmeldung DE 10 2006 017 622.7 der Anmelderin, angemeldet am 12. April 2006 mit dem Titel "Verfahren und Vorrichtung zur Herstellung von multikristallinem Silizium", deren Inhalt hiermit im Wege der Bezugnahme ausdrücklich mit beinhaltet sei, offenbart ein Verfahren zur Herstellung von multikristallinem Silizium nach dem VGF-Verfahren. Der Schmelztiegel wird dabei mit stückigem Si-Ausgangsmaterial so befüllt, dass die Innenwände des Schmelztiegels von Si-Platten, die von einem vorherigen Si-Ingot abgeschnitten wurden, bedeckt sind. Dadurch kann die Gefahr von Beschädigungen von Behälterinnenwänden durch scharfkantiges, stückiges Silizium erheblich reduziert werden. Zur Kompensation der Volumenschrumpfung beim Einschmelzen der in den Schmelztiegel eingebrachten Si-Schüttung wird auf diesen ein ringförmiger Tiegelaufsatz aufgesetzt und auch dieser mit der Si-Schüttung aufgefüllt.

Die Deutsche Patentanmeldung DE 10 2006 017 621.9 der Anmelderin, angemeldet am 12. April 2006 mit dem Titel "Vorrichtung und Verfahren zur Herstellung von ein- oder multikristallinen Materialien, insbesondere von multikristallinem Silizium", deren Inhalt hiermit im Wege der Bezugnahme ausdrücklich mit beinhaltet sei, offenbart die Herstellung von multikristallinem Silizium nach dem VGF-Verfahren. Um den Umfang des Schmelztiegels herum ist ein Mantelheizer vorgesehen, der ein inhomogenes Temperaturprofil erzeugt. Dieses entspricht dem Temperaturgradienten, der im Zentrum des Tiegels ausgebildet ist. Die Heizleistung des Mantelheizers nimmt von dem oberen Ende zu dem unteren Ende des Tiegels hin ab. Der Mantelheizer besteht aus einer Mehrzahl von parallelen Heizstegen, die sich mäanderförmig vertikal oder horizontal erstrecken. Die Heizleistung der Stege wird durch Variation des Leiterquerschnitts eingestellt. Zur Vermeidung einer örtlichen Unterkühlung an Eckbereichen des Tiegels sind an den Umkehrbereichen des mäanderförmigen Verlaufs der Stege Leiterquerschnittsverengungen vorgesehen.

US 4,404,172 offenbart die Herstellung von einkristallinen Halbleitermaterialien durch gerichtetes Erstarren nach dem Vertical-Gradien-Freeze-Verfahren (VGF), wobei ein vergleichsweise kleiner monokristalliner Keimkristall im Zentrum eines zylindrischen und vergleichsweise schlanken Schmelztiegels mit konischem Boden angeordnet wird. EP 0 372 794 B1 offenbart ein entsprechendes Verfahren.

Die Deutsche Patentschrift DD 298 532 A5 offenbart ein Verfahren zur Züchtung von Quarzkeimkristallen nach dem Hydrothermalverfahren, bei dem mehrere Plattenkeimteile zur Minimierung von Randspannungen in einer Klemmhalterung an den Kanten bündig aneinandergefügt werden und anschließend den hydrothermalen Kristallzüchtungsbedingungen ausgesetzt werden. Die aneinander gefügten Plattenkeimteile wachsen zu einem homogenen, störungsfreien Einkristall zusammen, der als Ausgangsmaterial für störungsfreie Keimkristallplatten mit größerer Fläche für nachfolgende Chargen verwendet wird.

US 4,381,214 offenbart ein Verfahren zur Herstellung von größeren Keimkristallen dadurch, dass zwei kleinere Keimkristallplatten in Kristallisationsrichtung versetzt zueinander durch Löten miteinander verbunden werden und der so ausgebildete Kristallverbund Kristallzüchtungsbedingungen ausgesetzt wird. Aus dem so hergestellten Einkristall kann der größere Keimkristall abgetrennt werden.

WO 2007/084934 A2, entsprechend US 2007/0169684 A1 und US 2007/0169684 A1, offenbart ein Verfahren zur Herstellung eines Si-Ingots mit quadratischer Grundfläche durch gerichtetes Erstarren. Vor dem Einbringen der Si-Schmelze wird dabei der Boden des Schmelztiegels mit einer Mehrzahl von monokristallinen Si-Platten vollständig bedeckt, die als Keimkristallplatten wirken. Die Kristallisationsrichtungen von benachbarten Si-Keimkristallplatten können auch alternierend wechseln. Die Temperatur am Boden des Schmelztiegels wird dabei so gesteuert, dass ein vollständiges Schmelzen der Keimkristallplatten verhindert ist.

N. Stoddard et al., "Casting Single Crystal Silicon: Novel Defect Profiles from BP Solar's Mono2 ™ Wafers", Solid State Phenomena Vols. 131-133 (2008), pages 1-8, online at http://www.scientific.net, offenbart die Charakterisierung von nach dem vorgenannten Verfahren hergestellten Si-Kristalle, wobei ein Schmelztiegel mit einer Grundfläche von 690 x 690 mm$^2$ verwendet wurde. Gemessen wurden in einigen der Experimente Versetzungsdichten von $7 \times 10^4$ cm$^{-2}$ bis $3 \times 10^5$ cm$^{-2}$, wobei in Mittenwafern eines Bricks sogar Versetzungsdichten von nur $10^3$ cm$^{-2}$ erreicht wurden. Alle Angaben beziehen sich aber nur auf große Flächen (large areas) innerhalb der Wafer.

EP 0 887 442 A1 und EP 0 748 884 A1 offenbaren ein Verfahren zur Herstellung eines polykristallinen Si-Ingots durch gerichtetes Erstarren in einem Schmelztiegel, bei dem vor dem Einbringen eines stückigen Si-Rohmaterials der Boden des Schmelztiegels mit einer Mehrzahl von monokristallinen Si-Keimkristallplatten vollständig ausgekleidet wird.

Patent Abstracts of Japan, publication no. 10-007493 und Übersetzung hierzu offenbaren ein entsprechendes Verfahren. Patent Abstracts of Japan, publication no. 10-194718 und Übersetzung hierzu offenbaren ein entsprechendes Verfahren, bei dem die Si-Schmelze in einem externen Schmelztiegel hergestellt und in den Schmelztiegel eingegossen wird.

Patent Abstracts of Japan, publication no. 2007-022815 und Übersetzung hierzu offenbaren ein entsprechendes Verfahren, bei dem der Boden des Schmelztiegels vor dem Einbringen von stückigem Si-Rohmaterial vollständig mit monokristallinen Si-Keimkristallen ausgekleidet wird.

**Zusammenfassung der Erfindung**

Aufgabe der vorliegenden Erfindung ist es, ein wirtschaftliches Verfahren zur kostengünstigen Herstellung von hochwertigen, versetzungsarmen monokristallinen Materialrohlingen durch gerichtetes Erstarren, insbesondere nach dem VGF-Verfahren und insbesondere von monokristallinen Metall- oder Halbmetallkörpern, bereitzustellen, bevorzugt von monokristallinem Silizium.

Diese und weitere Aufgaben werden gemäß der vorliegenden Erfindung durch ein Verfahren mit den Merkmalen nach Anspruch 1 gelöst. Weitere vorteilhafte Ausführungsformen sind Gegenstand der rückbezogenen Unteransprüche.

Somit geht die vorliegende Erfindung aus von einem Verfahren zur Herstellung eines monokristallinen Metall- oder Halbmetallkörpers durch gerichtetes Erstarren, insbesondere nach dem Vertical-Gradient-Freeze-Verfahren (VGF-Verfahren), bevorzugt von monokristallinen Siliziumkörpern, bei welchem Verfahren ein Halbmetall- oder Metall-Ausgangsmaterial in einem Schmelztiegel zu einer Schmelze geschmolzen wird und die Schmelze unter Einwirkung eines Temperaturgradienten, der in eine vertikale Richtung, vom oberen Ende des Schmelztiegels zu dessen unterem Ende, zeigt, zu dem monokristallinen Metall- oder Halbmetallkörper gerichtet erstarrt wird.

Bei dem Verfahren wird der Boden des Schmelztiegels vor dem Einbringen des Halbmetall- oder Metall-Ausgangsmaterials oder einer Halbmetall- oder Metallschmelze in den Schmelztiegel mit einer dünnen monokristallinen Keimkristallplattenschicht mit einer Kristallorientierung parallel zur vertikalen Richtung des Schmelztiegels bedeckt. Dabei wird die Temperatur des Bodens des Schmelztiegels während des gesamten Prozesses, einschließlich der Phase des gesamten gerichteten Erstarrens zu dem monokristallinen Halbmetall- oder Metallkörper, auf einer Temperatur unterhalb der Schmelztemperatur des Ausgangsmaterials gehalten, um ein Schmelzen der Keimkristallplattenschicht jedenfalls bis hinab zum Boden des Schmelztiegels zu verhindern.

Die Kristallorientierung der monokristallinen Keimkristallplattenschicht ist parallel zur gewünschten Kristallorientierung des herzustellenden Halbmetall- oder Metallkörpers. Somit kann die Keimkristallplattenschicht erfindungsgemäß das gerichtete Erstarren der Schmelze zu einem monokristallinen Körper mit Kristallorientierung in vertikaler Richtung bzw. senkrecht zum Boden des Schmelztiegels in einfacher aber zuverlässiger Weise vorgeben. Die Temperatur des Bodens des Schmelztiegels kann überwacht und geeignet gesteuert oder geregelt werden, beispielsweise durch Steuern oder Regeln der Temperatur einer im Bereich des Bodens vorgesehen Heizeinrichtung, der Temperatur einer im Bereich des Bodens vorgesehenen Kühleinrichtung, der Stellung einer Tiegelaufstellplatte in Bezug zu einer dort vorgesehenen Heizeinrichtung oder Kühleinrichtung, der Stellung eines verstellbaren Strahlungsschilds oder dergleichen. Durch geeignete Steuerung oder Regelung, sodass das die Temperatur des Bodens unterhalb der Schmelztemperatur des Halbmetalls oder Metalls ist, kann gewährleistet werden, dass die Keimkristallplattenschicht die Kristallorientierung zuverlässig vorgibt.

Die Keimkristallplattenschicht kann einstückig ausgebildet sein oder kann eine Mehrzahl von Keimkristallplatten umfassen, welche unmittelbar aneinander angrenzend auf dem Boden des Schmelztiegels angeordnet werden, um diesen vollständig zu bedecken. Hierzu eignen sich einfache geometrische Formen, die einander zu geschlossenen Flächen gut ergänzen, wie insbesondere rechteckförmige oder quadratische Grundflächen der Keimkristallplatten.

Die Keimkristallplatten weisen bevorzugt eine identische Dicke auf, um die Ausbildung von Versetzungen an der Grenzfläche zwischen Keimkristallplattenschicht und Schmelze beim gerichteten Erstarren der Schmelze zu unterdrücken. Die Dicke ist dabei bevorzugt so bemessen, dass Schwankungen der Temperatur im Bereich des Bodens des Schmelztiegels, wie diese insbesondere aufgrund von Zeitkonstanten der Steuerung oder Regelung auftreten, unter keinen Umständen zu einem Durchschmelzen der Keimkristallplattenschicht bis hinab zu dem Boden des Schmelztiegels bewirken können. Grundsätzlich ist die Dicke der Keimkristallplattenschicht jedoch bevorzugt zu minimieren, um die Herstellungskosten zu minimieren.

Die Keimkristallplattenschicht weist somit eine Form auf, welche im Wesentlichen durch den durch Boden und Seitenwände des Schmelztiegels vorgegebenen Gefäßquerschnitt festgelegt ist. Die Keimkristallplattenschicht ist bevorzugt ein abgetrenntes Teil eines Einkristalls, der in einem geeigneten vorherigen Prozess, wie nachfolgend beschrieben, hergestellt wird und der Abmessungen aufweist, die dem gesamten Gefäßquerschnitt der Bodenfläche des Schmelztiegels entsprechen, sodass der Tiegelboden vollständig bedeckt werden kann.

Bei dem Verfahren umfasst die dünne monokristalline Keimkristallplattenschicht, welche den Boden des Schmelztiegels vollständig bedeckt bzw. auskleidet, eine Mehrzahl von dünnen monokristallinen Keimkristallplatten, die unmittelbar aneinander angrenzend angeordnet werden und gleiche Abmessungen aufweisen, oder eine einzelne monokristalline Keimkristallplatte, in welcher zumindest eine Versatzlinie ausgebildet ist, welche die einzelne monokristalline Keimkristallplatte in zumindest zwei Keimkristallplattenunterabschnitte unterteilt, die jeweils die gleiche Breite in einer oder zwei Richtungen senkrecht zur vertikalen Richtung aufweisen.

Erfindungsgemäß wird der durch gerichtetes Erstarren hergestellte monokristalline Metall- oder Halbmetallkörper durch Sägen entlang von zumindest einer sich parallel zur Kristallorientierung erstreckenden Sägelinie in eine Mehrzahl von monokristallinen Metall- oder Halbmetallkörper unterteilt, wobei der Beginn der jeweiligen Sägelinie so gewählt wird, dass dieser entweder durch den Rand einer Keimkristallplatte oder durch eine jeweilige Versatzlinie innerhalb der einzelnen monokristallinen Keimkristallplatte festgelegt ist. Bei dem gerichteten Erstarren zu dem monokristallinen Metall- oder Halbmetallkörper resultieren die Ränder der mehreren Keimkristallplatten oder die zumindest eine Versatzlinie, die innerhalb einer einzelnen, den Boden des Schmelztiegels vollständig bedeckenden Keimkristallplatte ausgebildet ist, in Versatzlinien, die dem Verlauf der Ränder bzw. der zumindest einen Versatzlinie folgen und sich in Kristallwachsrichtung erstrecken. Weil der nach dem erfindungsgemäßen Verfahren hergestellte monokristalline Metall- oder Halbmetallkörper entlang dieser Versatzlinien in kleinere Blöcke zerlegt wird, weisen die so entstehenden kleineren Blöcke aus dem monokristallinen Metall- oder Halbmetallmaterial eine erheblich reduzierte Versetzungs- bzw. Ätzgrubendichte auf. Die so hergestellten monokristallinen Metall- oder Halbmetallblöcke eignen sich somit für anspruchsvolle Anwendungen, bei denen es auf eine geringe Versetzungs- oder Ätzgrubendichte ankommt, beispielsweise zur Herstellung von monokristallinen Siliziumzellen für die Photovoltaik.

Aufwändige Untersuchungen der Erfinder haben dabei ergeben, dass gerade durch das erfindungsgemäße Verfahren eine Lücke auf dem Markt für monokristallines Silizium für Anwendungen in der Photovoltaik geschlossen wird. Denn einerseits ist die Versetzungs- bzw. Ätzgrubendichte für nach dem erfindungsgemäßen Verfahren hergestellte monokristalline Siliziumwafer sogar Null bzw. praktisch infolge unvermeidbarer Prozessparameterschwankungen auch nicht allzu groß, sondern liegt vielmehr in einem mittleren Bereich von maximal $10^5$ cm$^{-2}$, der sich als vorteilhaft zur Herstellung hocheffizienter Solarzellen erwiesen hat. Während die Herstellung von versetzungsfreiem, monokristallinem Silizium nach dem CZ-Verfahren nur zu vergleichsweise hohen Kosten möglich ist, weist multikristallines Silizium, das gemäß dem Stand der Technik mit vergleichsweise kostengünstigen Verfahren hergestellt wird, herkömmlich eine hohe Versetzungsdichte oberhalb von $10^5$ cm$^{-2}$ auf, die in einem reduzierten Wirkungsgrad von <15,5% resultiert. Durch das erfindungsgemäße Verfahren kann diese im Stand der Technik bestehende Lücke geschlossen werden, kann also multikristallines Silizium mit einer Versetzungsdichte, die in einem akzeptablen mittleren Bereich liegt, zu wirtschaftlichen Kosten hergestellt werden.

Ohne auf diese theoretische Erklärung abschließend festgelegt werden zu wollen, geht man seitens der Erfinder derzeit davon aus, dass gerade durch das kontrollierte Einbringen von definierten Versatzlinien in einen großflächigen Ingot die notwendigen Randbedingungen geschaffen werden, um für eine Versetzungs- bzw. Ätzgrubendichte in dem resultierenden monokristallinen Material zu sorgen, die beim Einsatz von monokristallinen Keimplatten aus dem CZ-Verfahren Null sein kann, bei unvermeidlichen Störungen der Prozessführung bzw. bei Mehrfachnutzung von Keimplatten bzw. bei Nutzung von Material als Keimplatte, das aus einem Zuchtprozess mit Ersteinsatz von Keimplatten aus dem CZ-Verfahren erzeugt wurde, jedoch in einem mittleren Bereich von maximal $10^5$ cm$^{-2}$ liegt. Die in dem Bereich der Versatzlinien vorherrschende deutlich höhere Versetzungs- bzw. Ätzgrubendichte fällt nach dem erfindungsgemäßen Verfahren deshalb später nicht ins Gewicht, da die kleineren monokristallinen Blöcke gerade entlang dieser Versatzlinien abgetrennt werden.

Dabei spielt das Verhältnis der Grundfläche des Schmelztiegels zu der Grundfläche der kleineren Keimkristallplatten bzw. der versetzungslinienfreien Bereiche der einzelnen Keimkristallplatte eine wichtige Rolle. Bevorzugt wird die Grundfläche des Schmelztiegels möglichst groß gewählt und sollte das Herausschneiden von z.B. sechzehn (= 4x4) 6-Zoll-Bricks oder fünfundzwanzig (= 5x5) 6-Zoll-Bricks aus einem Ingot ermöglichen. Bevorzugt werden dabei Schmelztiegel mit Abmessungen von 720 x 720 mm oder 880 x 880 mm. Auf diese Grundfläche werden erfindungsgemäß bevorzugt zwei oder vier Keimkristallplatten oder versetzungslinienfreie Unterabschnitte der einzelnen Keimkristallplatte gleichmäßig verteilt.

Die Keimkristallplatten können dabei durch einen gesonderten Prozess mit sehr geringer Versetzungs- bzw. Ätzgrubendichte hergestellt werden, beispielsweise nach dem bekannten Czochralski-Verfahren. Bevorzugt wird von einem durch gerichtetes Erstarren und unter Verwendung mehrerer solcher Keimkristallplatten hergestelltem Ingot ein einzelner, großflächiger Keimkristall mit identischer Grundfläche wie der Schmelztiegel abgetrennt, ohne dass dieser entlang der Ränder der zu seiner Herstellung verwendeten Keimkristallplatten bzw. entlang der jeweiligen Versatzlinie in kleinere monokristalline Keimkristallblöcke zerlegt wird.

Somit geht die vorliegende Erfindung aus von einer Vorrichtung mit einem feststehenden Tiegel und einer Heizeinrichtung zum Aufschmelzen des in dem Tiegel befindlichen Siliziums. Dabei ist die Heizeinrichtung und/oder eine thermische Isolation der Vorrichtung so ausgelegt, um in dem Tiegel einen Temperaturgradienten in der Längsrichtung auszubilden. Dies erfolgt normalerweise dadurch, dass der Boden des Tiegels auf einer niedrigeren Temperatur gehalten wird als das obere Ende desselben. Ferner weist bei einer solchen Vorrichtung die Heizeinrichtung einen Mantelheizer zur Unterdrückung eines Wärmeflusses senkrecht zur Längsrichtung, das heißt horizontal auswärts gerichtet, auf.

Dabei ist der Mantelheizer ein Einzonenheizer, der so ausgelegt ist, dass seine Heizleistung in der Längsrichtung von dem oberen Ende zu dem unteren Ende hin abnimmt, um zur Aufrechterhaltung des in dem Tiegel ausgebildeten Temperaturgradienten zumindest beizutragen. Mit anderen Worten, durch Variieren der Heizleistung des Mantelheizers in Längsrichtung des Tiegels in stetiger oder diskreter Weise wird die Ausbildung eines vorbestimmten Temperaturgradienten in dem Tiegel zumindest unterstützt. Dieser Temperaturgradient wird in dem Schmelztiegel durch unterschiedliche Temperaturen eines Deckelheizers und einer Bodenheizers in an sich bekannter Weise vorgegeben. Dabei ist die Temperatur des Bodenheizers am Boden des Schmelztiegels niedriger, insbesondere unterhalb der Schmelztemperatur des zu verarbeitenden Siliziums. Zweckmäßig erstreckt sich dabei der Bodenheizer nicht zwangsläufig über die gesamte Grundfläche des Tiegels. Die Ausbildung einer ebenen Phasengrenzen in dem zu kristallisierenden Material, beispielsweise Silizium, ist mit einem sich über die Grundfläche des Tiegels sich erstreckenden Bodenheizer zwar am exaktesten realisierbar, aber eine in der Praxis ausreichend ebene Phasengrenze kann auch noch mit einem ringförmigen Bodenheizer erzielt werden, der in der Kristallisationsphase bezüglich seiner Temperaturabsenkung über die Prozesszeit sehr gut an das Temperaturprofil des Mantelheizers abgestimmt ist.

Erfindungsgemäß wird der Temperaturgradient zwischen oben und unten durch die in Längsrichtung des Schmelztiegels variierende Heizleistung des Mantelheizers nachgebildet, so dass über den gesamten Querschnitt des Tiegels, insbesondere auch im Bereich der Ecken des vieleckigen Tiegels, eine ebene Phasengrenze zwischen schon auskristallisiertem Silizium und dem noch geschmolzenen Silizium ausgebildet ist, also eine horizontal verlaufende Phasengrenze. Dies ermöglicht eine weitere Reduzierung der Versetzungsdichte in dem monokristallinen Halbmetall- oder Metallingot.

Erfindungsgemäß ist ferner kein Aufwand für eine thermische Isolation zwischen Tiegel und Mantelheizer erforderlich, weil der den Quarztiegel umschließende Graphittiegel ausreichend ist, um das vom Mantelheizer erzeugte Temperaturprofil ausreichend zu vergleichmäßigen. Ausreichende Vergleichmäßigung heißt dabei insbesondere, dass infolge der hohen thermischen Leitfähigkeit des äußeren Tiegelmaterials Graphit lokale Unterschiede bzgl. der vom Mantelheizer abgestrahlten Wärme ausgeglichen werden. Das sich so in der Graphittiegelwand herausbildende vertikale Temperaturprofil wird durch die Tiegelwand des schwach wärmeleitfähigen Quarztiegels hindurch an die innere Wand des Quarztiegels nahezu unverändert übertragen. An der Kontaktfläche von schmelzflüssigem Silizium und Quarztiegel fällt die Temperatur von oben nach unten monoton und angenähert linear ab. Dadurch kann trotz Wegfall der Schicht aus thermischem Isolationsmaterial eine ebene, horizontale Phasengrenze zwischen dem auskristallisierten Silizium und dem noch geschmolzenen Silizium gewährleistet werden. Dies ermöglicht bei gleichen Außenabmessungen der Kristallisationsanlage einen insgesamt größeren Querschnitt des Tiegels und auch eine größere Höhe des Tiegels und somit erfindungsgemäß die Bereitstellung von massereicheren Silizium-Ingots, was in erheblichen Kostenvorteilen resultiert. Der erfindungsgemäße Einzonenmantelheizer mit definiert einstellbarem Temperaturprofil über die Mantelhöhe ist bei der Herstellung von monokristallinem Silizium von besonderem Vorteil, wenn mit Quarztiegeln einer Höhe von mehr als etwa 250 mm, insbesondere mehr als etwa 300 mm und ganz besonders bevorzugt mehr als 350 mm gearbeitet wird.

Die Heizleistung des den Tiegel umgebenden flächigen Heizelements, insbesondere eines Mantelheizers, kann erfindungsgemäß durch einfache Maßnahmen, wie beispielsweise Variation des geometrischen Querschnitts des Mantelheizers, geeignet eingestellt werden. Insbesondere kann der Mantelheizer so in einfacher Weise auf die geometriebedingten thermischen Eigenschaften des Tiegels abgestimmt werden.

Erfindungsgemäß weist der Tiegel einen rechteckförmigen oder quadratischen Querschnitt auf, so dass rechteckförmige oder quadratische Elemente, bevorzugt Silizium-Elemente, mit vorteilhaft geringem Verschnitt aus dem Silizium-Ingot herausgeschnitten werden können.

Die erfindungsgemäße Vorrichtung beruht deshalb auf der Abkehr von dem üblichen Konzept, einen rotationssymmetrischen Schmelztiegel zur Herstellung von monokristallinem Silizium zu verwenden. Im Unterschied zum Stand der Technik weist der um den Tiegel angeordnete Heizer dieselbe Kontur auf wie der Tiegel. Ein beispielsweise quadratischer Tiegel ist also von einem quadratischen Heizer umgeben. Auf die übliche Wärmeisolationsschicht zwischen Heizer und Tiegel wird verzichtet.

Erfindungsgemäß nimmt die Heizleistung des Einzonenmantelheizers in der Längsrichtung des Tiegels von oben nach unten in Entsprechung zu dem Temperaturgradienten im Zentrum des Tiegels ab. Insbesondere nimmt die Heizleistung des Mantelheizers je Längeneinheit exakt in demselben Verhältnis ab, in dem der Temperaturgradient im Zentrum des Tiegels abnimmt. Durch diese exakte insbesondere proportionale Nachbildung des Temperaturgradienten im Zentrum des Tiegels über den gesamten Umfang desselben, können erfindungsgemäß ebene Phasengrenzen zwischen schon auskristallisiertem Silizium und noch geschmolzenem Silizium über den gesamten Querschnitt des Tiegels in einfacher Weise gewährleistet werden, insbesondere auch in Eckbereichen des Tiegels.

Gemäß einer weiteren Ausführungsform werden durch den Mantelheizer eine Mehrzahl von ebenen Isothermen senkrecht zur Längsrichtung des Tiegels vorgegeben oder aufrechterhalten. Die resultierende ebene Phasengrenze über den gesamten Querschnitt des Tiegels führt zu einer vorteilhaften Reduzierung von Kristallbaufehlern und somit zu einer vorteilhaft geringen Ätzgrubendichte von erfindungsgemäß hergestelltem Siliziumwafern.

Insbesondere bei Tiegeln mit rechteckförmigem oder quadratischem Querschnitt wurden erhöhte Wärmeverluste aufgrund einer je Volumeneinheit größeren abstrahlenden Oberfläche festgestellt. Solche erhöhten Wärmestrahlungsverluste treten in abgemildeter Form auch bei vieleckigen Tiegeln mit einem anderen als rechteckförmigen oder quadratischen Querschnitt auf. Zur Kompensation solcher unerwünschter erhöhter Wärmeverluste ist die Heizleistung des Mantelheizers in Eckbereichen des Tiegels höher oder ist alternativ ein Abstand zwischen der Tiegelwand und dem Mantelheizer in den Eckbereichen des Tiegels kleiner gewählt. Die Heizleistung des Mantelheizers kann dabei in den Eckbereichen stetig oder in einem oder mehreren diskreten Schritten erhöht werden. Alternativ kann der Abstand zwischen der Tiegelwand und dem Mantelheizer stetig oder in einem oder mehreren Schritten verkleinert werden. Insbesondere kann der Mantelheizer in den Eckbereichen stetig gekrümmt ausgebildet sein, mit einem Minimum des Abstands auf einer gedachten Verlängerung einer Linie vom Zentrum des Tiegels zur jeweiligen Ecke des Tiegels, wobei dieser minimale Abstand kleiner ist als in Bereichen der Tiegelwand außerhalb des jeweiligen Eckbereichs.

Bei Tiegeln mit rechteckförmigem oder quadratischem Querschnitt, die erfindungsgemäß eingesetzt werden, umfasst der Mantelheizer um die Seitenflächen des Tiegels angeordnete Heizelemente, die in der Längsrichtung des Tiegels oder senkrecht dazu einen mäanderförmigen Verlauf aufweisen. Auf diese Weise wird eine vergleichsweise gleichmäßige Wärmebeaufschlagung der Tiegelwand erzielt und kann die elektronische Auslegung des Mantelheizers dennoch in einfacher Weise in Entsprechung zu dem Temperaturgradienten in dem Schmelztiegel variiert werden. Dabei wird eine Spaltbreite zwischen den Stegen des mäanderförmigen Verlaufs des Mantelheizers zweckmäßig so gewählt, dass die gut wärmeleitende Graphittiegelwand selbst zu einer ausreichenden Glättung des Temperaturprofils führt. Die Spaltbreite zwischen Stegen des Mantelheizers hängt somit insbesondere auch von der Wärmeleitfähigkeit des Materials oder der Materialien des inneren Tiegels, beispielsweise des Quarztiegels, und des äußeren Stütztiegels, beispielsweise des Graphittiegels ab. Zweckmäßig wird die Spaltbreite dabei so gewählt, dass eine dadurch bedingte Inhomogenität des Temperaturprofils auf der Wand des Tiegels kleiner als eine vorbestimmte Temperaturabweichung ist, die bevorzugt kleiner als etwa 5 K, bevorzugter kleiner als etwa 2K und noch bevorzugten kleiner als etwa 1 K ist.

Erfindungsgemäß sind die Heizelemente als sich senkrecht zur Längsrichtung erstreckende, rechteckförmig Stege ausgebildet, die in Längsrichtung des Tiegels einen mäanderförmigen Verlauf aufweisen und deren Leiterquerschnitte von dem oberen Ende zu dem unteren Ende des Tiegels hin in mehreren diskreten Schritten zunehmen. Ein solchermaßen ausgebildeter Mantelheizer kann durch einfaches Verbinden vorgeformter Einzelteile, insbesondere aus Graphit, oder Gießen eines geeigneten Heizleitermaterials, in geeigneter geometrischer Ausbildung geformt werden.

Zweckmäßig verlaufen dabei die Stege des Mantelheizers mit mäanderförmigem Verlauf äquidistant und parallel zueinander. Die sich horizontal bzw. senkrecht zur Längsrichtung erstreckenden Stege definieren somit Isothermen, die sich über den gesamten Umfang des Tiegels auf gleichem Höhenniveau erstrecken und somit automatisch zur Ausbildung von Ebenen, horizontalen Phasengrenzen in dem Tiegel führen. Die Verlaufsrichtung der Stege wird dabei an Umkehrbereichen, die den Eckbereichen des Tiegels gegenüberliegen, invertiert. Mit der Geometrie der Umkehrbereiche, insbesondere deren Leiterquerschnitte, steht somit ein einfacher Parameter zur Verfügung, um die thermischen Verhältnisse in den Eckbereichen des Tiegels gezielt vorzugeben.

Bei Tiegeln mit rechteckförmigem oder quadratischem Querschnitt, die erfindungsgemäß eingesetzt werden, umfasst der Mantelheizer um die Seitenflächen des Tiegels angeordnete Heizelemente, die in der Längsrichtung des Tiegels oder senkrecht dazu einen mäanderförmigen Verlauf aufweisen. Auf diese Weise wird eine vergleichsweise gleichmäßige Wärmebeaufschlagung der Tiegelwand erzielt und kann die elektrotechnische Auslegung des Mantelheizers dennoch in einfacher Weise in Entsprechung zu dem Temperaturgradienten in dem Schmelztiegel variiert werden. Dabei wird eine Spaltbreite zwischen den Stegen des mäanderförmigen Verlaufs des Mantelheizers zweckmäßig so gewählt, dass die gut wärmeleitende Graphittiegelwand selbst zu einer ausreichenden Glättung des Temperaturprofils führt. Die Spaltbreite zwischen Stegen des Mantelheizers hängt somit insbesondere auch von der Wärmeleitfähigkeit des Materials des inneren Tiegels(z.B. Quarztiegel) und des äußeren Stütztiegels(z.B. Graphittiegel) ab. Zweckmäßig wird die Spaltbreite dabei so gewählt, dass eine dadurch bedingte Inhomogenität des Temperaturprofils auf der Wand des Tiegels kleiner als eine vorbestimmte Temperaturabweichung ist, die bevorzugt kleiner als etwa 5 K, bevorzugter kleiner als etwa 2K und noch bevorzugten kleiner als etwa 1 K ist.

Bei Tiegeln mit rechteckförmigem oder quadratischem Querschnitt, die erfindungsgemäß eingesetzt werden, sind im Bereich der Ecken besondere Vorkehrungen vorgesehen, um die angestrebten horizontalen Isothermen auch dort zu gewährleisten. Einfache Umkehrungen in Form von vertikalen Heizstegen bei ansonsten horizontal, mäanderformig verlaufenden Heizstegen können im Bereich der Diagonalen der Umkehrbereiche ohne weitere Maßnahmen zur Leitungsquerschnittsverringerung zu einem lokal vergrößerten Leitungsquerschnitt und damit zu einer verringerten Heizleistung mit der Folge geringerer Oberflächentemperatur auf dem Heizer führen. Eine Isothermie je Längskoordinate des Tiegels wäre somit nicht zu gewährleisten. An den Ecken käme es dann zu einem unerwünschten Temperaturabfall mit negativen Auswirkungen (Spannungen in den Ecken, dadurch bedingte hohe Defektdichte und Mikrorisse, die zu Ausbeuteverlusten führen). Zur Kompensation solcher Abweichungen von der gewünschten Isothermie je Längskoordinate sind erfindungsgemäß verschiedene Maßnahmen möglich. Der Abstand zwischen der Tiegelwand und dem Mantelheizer in den Eckbereichen des Tiegels kann stetig oder in einem oder mehreren Schritten verkleinert werden, da die Forderung nach Isothermie grundsätzlich nur in der Kristallisationsphase besteht. Insbesondere kann der Mantelheizer in den Eckbereichen stetig gekrümmt ausgebildet sein, mit einem Minimum des Abstands auf einer gedachten Verlängerung einer Linie vom Zentrum des Tiegels zur jeweiligen Ecke des Tiegels, wobei dieser minimale Abstand kleiner ist als in Bereichen der Tiegelwand außerhalb des jeweiligen Eckbereichs.

Erfindungsgemäß ist dabei ein Leiterquerschnitt der Stege an den Umkehrbereichen des mäanderförmigen Verlaufs in Diagonalrichtung so verengt, dass er dem Leitungsquerschnitt des Stegs vor oder nach dem jeweiligen Umkehrbereich gleicht. Dies führt zu einer Beibehaltung des elektrischen Widerstands und somit zu einer gleichen Heizleistung bzw. Oberflächentemperatur im Umkehrbereich der Stege wie im Bereich der horizontal verlaufenden Stege.

Gemäß einer weiteren Ausführungsform sind die Verengungen des Leiterquerschnitts an den Umkehrbereichen in kontrollierter Weise durch eine Mehrzahl von Lochungen oder Ausnehmungen in bzw. aus dem Stegmaterial ausgebildet, die quer zum Leiterquerschnitt verteilt angeordnet sind. Durch die Geometrie und die Abmessungen der Lochungen oder Ausnehmungen kann somit der Leiterquerschnitt bzw. der elektrische Widerstand in den Umkehrbereichen an den der Stege angepasst werden. Die Verlaufsrichtung der Lochungen oder Ausnehmungen stellen dabei Varianten dar, die alle zur Vergleichmäßigung der horizontalen Temperaturverteilung über den Umfang des Tiegels in jeder Höhenkoordinate führen können. Bei insgesamt rechteckförmigem Verlauf der Stege können sich die Lochungen bzw. Ausnehmungen insbesondere entlang einer die Eckbereiche der Stege verbindenden Diagonalen erstrecken. Insgesamt ist es zweckmäßig, wenn sich die Mehrzahl von Lochungen bzw. Ausnehumungen spiegelsymmetrisch oder nahezu spiegelsymmetrisch um eine gedachte Spiegelachse im Zentrum des Spalts zwischen zwei zueinander benachbarten Stegen erstrecken.

Gemäß der vorliegenden Erfindung sind die Heizelemente als sich in der Längsrichtung erstreckende rechteckförmige Stege ausgebildet, deren Leiterquerschnitt von dem oberen Ende zu dem unteren Ende des Tiegels hin in einer Mehrzahl von diskreten Schritten zunimmt. Dabei sind sämtliche sich in Längsrichtung bzw. vertikal erstreckende Stege gleich ausgebildet, so dass in Längsrichtung des Tiegels betrachtet eine Vielzahl von ebenen, horizontalen Isothermen in quasi kontinuierlicher oder diskreter Weise durch den Mantelheizer festgelegt werden. Dabei ist die Spaltbreite zwischen den Stegen, wie vorstehend beschrieben, so gewählt, dass das gut wärmeleitende Material des Tiegels zu einer ausreichenden Vergleichmäßigung des Temperaturprofils zwischen den Stegen des Mantelheizers sorgt. In jedem Fall führen die Bereiche zwischen den Stegen nicht zu Abweichungen vom monotonen und nahezu linear verlaufenden Temperaturanstieg in zunehmender Längskoordinate des Tiegels, wobei hier immer Orte des Zusammentreffens des zu kristallisierenden Materials mit der inneren Tiegelwand betrachtet werden.

Gemäß einer weiteren Ausführungsform ist der Mantelheizer aus Einzelsegmenten gefertigt, die gegebenenfalls, etwa im Falle einer lokalen Beschädigung oder dann, wenn der Mantelheizer anders ausgelegt werden soll, ausgebaut und durch ein anderes Segment ersetzt werden können. Ein solcher modularer Aufbau hat sich insbesondere für Mantelheizer bestehend aus einer Mehrzahl von Heizstegen mit mäanderförmigem Verlauf bewährt. Dabei müssen die Segmente so verbunden werden, dass an den Verbindungsstellen ein ungehinderter Stromfluss gewährleistet ist, was gewisse Kompromisse bei der Wahl der Verbindungsart und der Materialien bedingt. Insbesondere können die Segmente mit Hilfe von Verbindungselementen, wie beispielsweise Keilen oder Stopfen mit einem identischen oder geringfügig größeren Wärmeausdehnungskoeffizienten, oder mit Hilfe anderer Form-, Reib- oder Kraftschlusselemente, insbesondere Schrauben oder Nieten, lösbar miteinander verbunden sein. Gemäß einer anderen Ausführungsform können die Segmente auch stoffschlüssig miteinander verbunden sein, beispielsweise durch Löten oder Schweißen.

Ein weiterer Gesichtspunkt betrifft die Verwendung eines Verfahrens, wie vorstehend beschrieben, zur Herstellung eines monokristallinen Silizium-Ingots mittels eines Vertical-Gradient-Freeze-Kristallziehverfahrens (VGF-Verfahrens) als Ausgangsmaterial für die Herstellung von photovoltaischen Bauelementen.

Ein weiterer Gesichtspunkt betrifft monokristalline Silizium-Wafer, hergestellt durch Sägen aus einem durch Ausführen des vorstehend beschriebenen Verfahrens hergestellten Silizium-Ingot, wobei erfindungsgemäß die mittlere Versetzungsdichte (etch pitch density; EPD) niedriger als $10^5$ cm$^{-2}$ ist. Dieser Wert wird an jedem Wafer erzielt, der aus dem Ingot herausgeschnitten wird, der nach dem erfindungsgemäßen Verfahren hergestellt wird. Rand-, Boden und Deckelbereiche des Ingots sowie Bereiche des Ingots mit SiC- oder SiN-Einschltissen sind hierbei ausgenommen, da diese Bereiche eines Si-Ingots auch nach Stand der Technik nicht zu Wafern aufgesägt werden. Je nachdem, ob die Keimplatten, die ursprünglich aus einem Chochralski-Prozess stammen, mehrfach verwendet werden oder erst aus einem Ingot gewonnen wurden, der unter Nutzung der originalen Chochralski-Keimplatten mit Versetzungsdichte Null gezüchtet wurde, werden als mittlere Versetzungsdichte eines Wafers noch deutlich geringere Werte als $10^5$ cm$^{-2}$ erreicht. Diese mittleren Versetzungsdichten eines Wafers betragen weniger als $5 \times 10^4$ cm$^{-2}$, bevorzugter weniger als $10^4$ cm$^{-2}$, noch bevorzugter weniger als $10^3$ cm$^{-2}$ und noch bevorzugter weniger als $10^2$ cm$^{-2}$. Infolge unvermeidbarer Prozessparameterschwankungen werden mittlere Versetzungsdichten eines Wafers von weniger als $10^3$ cm$^{-2}$ oder gar weniger als $10^2$ cm$^{-2}$ nicht an jedem Wafer gemessen, der aus einem nach dem erfindungsgemäßen Verfahren hergestellten Ingot herausgesägt wurde, sondern nur bei einem Anteil. Untersuchungen der Erfinder haben dabei ergeben, dass sich unter ansonsten gleichen Prozessbedingungen eine solch vorteilhaft niedrige mittlere Versetzungsdichte nur durch Verwendung einer Keimkristallplattenschicht, wie vorstehend beschrieben, beim gerichteten Erstarren einer Schmelze in einem großvolumigen Schmelztiegel erzielen lässt. Zur Messung der vorgenannten Versetzungsdichten wurden dabei stets Rand-, Boden und Deckelbereiche des Ingots sowie Bereiche des Ingots mit SiC- oder SiN-Einschlüssen ausgenommen.

## Figurenübersicht

Nachfolgend wird die Erfindung in beispielhafter Weise und unter Bezugnahme auf die beigefügten Zeichnungen beschrieben werden, woraus sich weitere Merkmale, Vorteile und zu lösende Aufgaben ergeben werden. Es zeigen:

Fig. 1  in einer schematischen Querschnittsdarstellung eine Vorrichtung zur Herstellung von monokristallinem Silizium gemäß der vorliegenden Erfindung;

Fig. 2a  in einer schematischen Schnittansicht die Befüllung des Schmelztiegels vor dem Aufschmelzen bei einem Verfahren gemäß der vorliegenden Erfindung;

Fig. 2b  in einer schematischen Schnittansicht die Befüllung des Schmelztiegels vor dem Aufschmelzen bei einem weiteren Verfahren gemäß der vorliegenden Erfindung;

Fig. 2c  in einer schematischen Schnittansicht die Befüllung des Schmelztiegels vor dem Aufschmelzen bei einem weiteren Verfahren gemäß der vorliegenden Erfindung;

Fig. 2d  in einer schematischen Schnittansicht die Befüllung des Schmelztiegels vor dem Aufschmelzen bei einem weiteren Verfahren gemäß der vorliegenden Erfindung;

Fig. 3a  in einer schematischen Draufsicht die Ausrichtung der bei dem Verfahren nach der Fig. 2a verwendeten Keimkristallplatten in Bezug zu den Sägelinien, entlang denen der monokristalline Si-Ingot nach dem Erstarren in kleinere Blöcke unterteilt wird, gemäß einer ersten Ausführungsform der vorliegenden Erfindung;

Fig. 3b  in einer schematischen Seitenansicht die Geometrie gemäß der Fig. 3a;

Fig. 3c  in einer schematischen Draufsicht die Ausrichtung der bei dem Verfahren nach der Fig. 2a verwendeten Keimkristallplatten in Bezug zu den Sägelinien, entlang denen der monokristalline Si-Ingot nach dem Erstarren in kleinere Blöcke unterteilt wird, gemäß einer zweiten Ausführungsform der vorliegenden Erfindung;

Fig. 3d  in einer schematischen Seitenansicht die Geometrie gemäß der Fig. 3c;

Fig. 4  den Verlauf der Grenze zwischen monokristalliner Phase und multikristalliner Phase bei einer modifizierten Ausführungsform der vorliegenden Erfindung, die zur Herstellung von großflächigen Keimkristallplatten aus vergleichsweise kleinen Keimkristallplatten verwendet wird;

Fig. 5  in einer schematischen Draufsicht einen Mantelheizer mit einem mäanderförmigen Verlauf der Heizstege bei einem Verfahren gemäß der vorliegenden Erfindung;

Fig. 6a  in einer schematischen Darstellung Maßnahmen zur Verengung des Leiterquerschnitts gemäß einer weiteren Ausführungsform der vorliegenden Erfindung;

Fig. 6b  Maßnahmen zur Verengung des Leiterquerschnitts gemäß einer weiteren Ausführungsform der vorliegenden Erfindung;

Fig. 6c  Maßnahmen zur Verengung des Leiterquerschnitts gemäß einer weiteren Ausführungsform der vorliegenden Erfindung;

Fig. 7a-7c  in einer schematischen Draufsicht unterschiedliche Verbindungsarten zur Verbindung von Stegen des Mantelheizers gemäß der Fig. 5; und

Fig. 7d  in einer perspektivischen Ansicht eine weitere Verbindungsart zur Verbindung von Stegen des Mantelheizers gemäß der Fig. 5.

In den Figuren bezeichnen identische Bezugszeichen identische oder im Wesentlichen gleich wirkende Elemente oder Elementsgruppen.

## Ausführliche Beschreibung von bevorzugten Ausführungsbeispielen

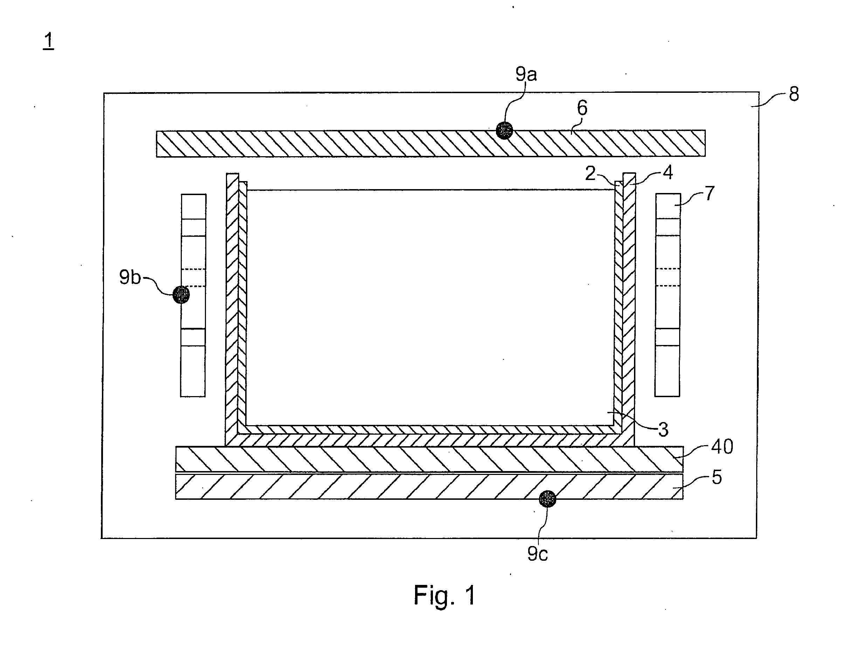

Die Fig. 1 zeigt ein Beispiel für eine Kristallisationsanlage zum gerichteten Erstarren einer Schmelze nach einem Vertical-Gradient-Freeze-Verfahren (VGF), die bei einem erfindungsgemäßen Verfahren eingesetzt wird. Die insgesamt mit dem Bezugszeichen 1 bezeichnete Anlage weist einen Tiegel mit viereckigem Querschnitt auf. Gemäß der Fig. 1 ist der Tiegel von einem Quarztiegel 2 ausgebildet, der zur Abstützung in einem korrespondierend ausgebildeten Graphitbehälter 4 eng anliegend aufgenommen ist. Das in dem Tiegel 2 aufgenommene Silizium 3 gelangt somit nicht in Anlage zu dem Graphitbehälter 4. Der Tiegel ist aufrecht stehend angeordnet, so dass die Tiegelwände entlang der Richtung der Schwerkraft verlaufen. Der Quarztiegel 2 ist ein kommerziell erhältlicher Quarztiegel mit einer Grundfläche von beispielsweise 570 x 570 mm, 720 x 720 mm. 880x880mm oder 1040 x 1040 mm und weist eine Innenbeschichtung als Trennschicht zwischen $SiO_2$ des Tiegels und Silizium auf. Ganz besonders bevorzugt weist der Quarztiegel eine Grundfläche von 720 x 720 mm auf.

Oberhalb und unterhalb des Tiegels befindet sich ein Deckelheizer 6 bzw. ein Bodenheizer 5, wobei zwischen dem Tiegel und dem Bodenheizer 5 eine Tiegelaufstellplatte 40, beispielsweise aus Graphit, angeordnet ist, die in der Darstellung nur schematisch angedeutet ist. Dabei ist die eigentliche Halterung des vorgenannten Tiegels so ausgebildet, dass zwischen dem Bodenheizer 5 und der den Tiegel abstützenden Tiegelaufstellplatte 40 ein schmaler Spalt ausgebildet ist. Umgeben wird die Kernzone des Tiegels von einem flächigen Heizelement, nämlich einem Mantelheizer 7, der nachfolgend ausführlicher beschrieben werden wird. Der Mantelheizer erstreckt sich im Wesentlichen über die gesamte Höhe des Tiegels. Bei dem VGF-Kristallisationsverfahren sind alle Heizer 5-7 temperaturgeregelt. Dazu werden die Oberflächentemperaturen der Heizer durch Pyrometer 9a-9c an geeigneter Stelle, wie beispielhaft in der Fig. 1 dargestellt, erfasst und in eine Steuerungseinheit eingegeben, die den durch die Heizer 5-7 fließenden Konstantstrom geeignet steuert bzw. regelt.

Alternativ oder ergänzend kann die mit dem Bezugszeichen 5 bezeichnete Platte auch als Kühlplatte ausgebildet sein, die von einem Kühlmittel unter Einwirkung einer geeigneten Steuerung oder Regelung durchströmt werden kann. Die Tiegelaufstellplatte 40 kann dann als Isolationsplatte ausgebildet sein, beispielsweise aus Graphit. Dabei ist die eigentliche Halterung des Tiegels so ausgebildet, dass zwischen der den Tiegel abstützenden Tiegelaufstellplatte 40 und der Kühlplatte 5 ein schmaler Spalt ausgebildet ist.

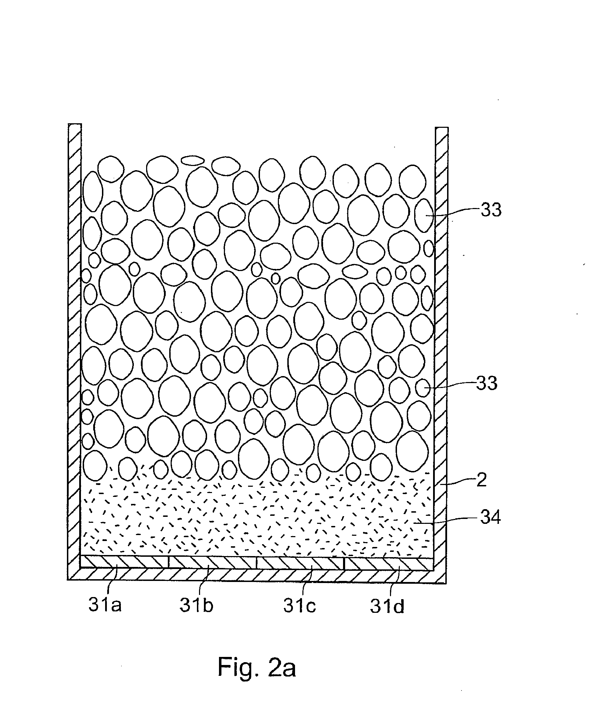

Das VGF-Verfahren kann erfindungsgemäß so gefahren werden, dass der Schmelztiegel zunächst mit einer Silizium-Schüttung aufgefüllt wird, wie nachfolgend anhand der Figuren 2a-2d beschrieben. Zuerst werden alle Heizer 5-7 auf unterschiedliche Temperaturen so hochgefahren, dass das gesamte im Tiegel befindliche Silizium aufgeschmolzen wird. Zum Auskristallisieren der Silizium-Schmelze werden der Bodenheizer 5 und der Deckelheizer 6 derart geregelt, dass der Deckelheizer 6 auf einer Temperatur oberhalb der Schmelztemperatur des zu verarbeitenden Siliziums gehalten wird und der Bodenheizer 5 zunächst auf eine Temperatur knapp unterhalb der Schmelztemperatur des zu verarbeitenden Siliziums gebracht wird. Dies führt zunächst zur Auskristallisation am Boden des Tiegels. Da sich die zur Temperaturvergleichmäßigung eingebrachte Bodenplatte 40 über die gesamte Fläche des Bodens des Tiegels erstreckt, kristallisiert das Silizium nicht nur im Zentrum sondern am gesamten Boden des Tiegels gleichmäßig aus. Anschließend wird die Temperatur eines jeden der drei dargestellten Heizer parallel zu den anderen Heizern heruntergefahren, so dass die Schmelze in dem Tiegel kontinuierlich nach oben erstarren kann, wobei die Phasengrenze zwischen dem schon auskristallisierten und dem noch geschmolzenen Material horizontal, also senkrecht zur Richtung der Schwerkraft, verläuft.

Gemäß der Fig. 1 ist zwischen der Tiegelwand 2, 4 und dem Mantelheizer 7 keine weitere thermische Isolation vorgesehen. Vielmehr wird erfindungsgemäß durch geeignete geometrische Auslegung des Mantelheizers 7, wie nachfolgend ausführlicher beschrieben, dafür gesorgt, dass der von dem Deckelheizer 6 und dem Bodenheizer 5 in dem Tiegel vorgegebene Temperaturgradient durch die von dem Mantelheizer abgegebene Heizleistung unterstützt oder aufrechterhalten wird. Zu diesem Zweck ist die von dem Mantelheizer abgegebene Heizleistung örtlich nicht konstant sondern nimmt in Längsrichtung des Tiegels vom oberen Ende zum unteren Ende hin ab, und zwar in Entsprechung zu dem Temperaturgradienten im Zentrum des Tiegels während der allmählichen Erstarrung der Silizium-Schmelze.

Nachfolgend werden anhand der Figuren 2a bis 2d Vorgehensweisen zum Auffüllen des Schmelztiegels mit einer Silizium-Schüttung bei einem Verfahren gemäß der vorliegenden Erfindung beschrieben.

Gemäß der Fig. 2a ist in das Innere des Tiegels 2 eine Silizium-Schüttung aus stückigem oder granularem Silizium 33 eingebracht. Geeignete Ausgangsmaterialien können sein:

- Silizium-Platten, die von den Seiten früherer geschmolzener Ingots abgesägt wurden und somit automatisch im Wesentlichen die Abmessungen der Innenwände des Tiegels aufweisen, diese also im Wesentlichen vollständig abdecken können;
- Große, grobe Silizium Stücke, die aus einem Recycling-Prozess (Reinigungsprozess) von Abfallmaterial stammen;
- Silizium-Bruch, insbesondere aus vorherigen Chargen;
- Silizium-Wafer bzw. Waferbruch;
- Silizium-Granulat (mittlerer Körnung) in Form von käuflichem Rohstoff;
- Silizium-Granulat (feine Körnung) in Form von käuflichem Rohstoff.

Die Silizium-Schüttung erstreckt sich gemäß der Fig. 2a vor dem Aufschmelzen im Wesentlichen bis zum oberen Rand des Tiegels 2. Gemäß der Fig. 2a ist unterhalb der groben Silizium-Schüttung 33 ein Si-Granulat 34 mittlerer oder feiner Körnung eingebracht. Gemäß der Fig. 2a ist der Boden des Schmelztiegels 2 mit einer Mehrzahl von Keimkristallplatten 31a-31d aus monokristallinem Silizium vergleichsweise geringer Dicke im Wesentlichen vollständig bedeckt. Die Kristallorientierung dieser Keimkristallplatten 31a-31d ist vertikal, d.h. parallel zu der gewünschten Wachstumsrichtung des herzustellenden monokristallinen Siliziums.

Die Keimkristallplatten 31a-31d haben bevorzugt eine identische Dicke und grenzen unmittelbar aneinander an, sodass der Boden des Schmelztiegels vollständig ausgekleidet ist. Die Keimkristallplatten 31a-31d sind bevorzugt rechteckförmig oder quadratisch, wobei jedoch grundsätzlich beliebige andere Geometrien zulässig sind, die eine im Wesentlichen vollständige Bedeckung des Bodens des Schmelztiegels ermöglichen.

Zum Aufschmelzen des Siliziums heizt der Deckelheizer 6 die Silizium-Schüttung von oben her auf eine Temperatur oberhalb der Schmelztemperatur des Siliziums. Die Energiezufuhr kann zusätzlich auch über den seitlichen Mantelheizer 7 und den Bodenheizer 5 erfolgen. Die Silizium-Schüttung wird also am oberen Rand des Tiegels zuerst aufgeschmolzen. Das aufgeschmolzene, flüssige Silizium läuft nun durch die darunter befindliche Silizium-Schüttung nach unten, um sich am Boden des Quarztiegels 2 zu sammeln.

Schließlich wird der Zustand gemäß der Fig. 1 erreicht, in dem die Silizium-Schmelze den Quarztiegel 2 bis zu dessen oberen Rand hin aufgefüllt hat. Während der gesamten Prozessführung wird darauf geachtet, dass die Temperatur des Bodens des Schmelztiegels 2 auf einer Temperatur unterhalb der Schmelztemperatur des Siliziums verbleibt, sodass die Keimkristallplatten 31 a-31 d auf dem Boden des Tiegels 2 nicht schmelzen, jedenfalls nicht bis hinab zum Boden des Tiegels 2 durchschmelzen. Ein geringfügiges Anschmelzen an der Oberseite der Keimkristallplatten 31a-31d ist durchaus erwünscht, solange dadurch die von der Kristallorientierung der Keimkristallplatten 31a-31d vorgegebene Ausrichtung des Kristallwachstums nicht beeinträchtigt wird.

Anschließend beginnt die gerichtete Abkühlung und Erstarrung des flüssigen Siliziums zu einem monokristallinen Silizium-Ingot. Nunmehr wird der Bodenheizer auf einer definierten Temperatur unterhalb der Schmelztemperatur des Siliziums gehalten, beispielsweise auf einer Temperatur von mindestens 10 K unterhalb der Schmelztemperatur. Am Boden des Schmelztiegels kommt es nun zur Initiierung des Kristallwachstums. Nach kurzer Zeit stellt sich ein Gleichgewichtstemperaturprofil ein und das initiierte Kristallwachstum kommt zum Erliegen. In diesem Zustand haben Decken- und Bodenheizer den gewünschten Temperaturunterschied, welcher gleich dem Temperaturunterschied zwischen oben und unten im Mantelheizer ist. Jetzt wird die Heizleistung der Heizer 5-7 reduziert und zwar jeder parallel zueinander. Es kommt zu einem kolumnaren Wachstum eines monokristallinen Si-Blocks, wobei die Wachstumsrichtung des entstehenden Si-Einkristalls durch die Kristallorientierung der Keimkristallplatten 31a-31d vorgegeben ist. Entsprechend der horizontalen Phasengrenze erfolgt das Wachstum parallel und senkrecht von unten nach oben. Der so erhaltene monokristalline Si-Ingot wird dann auf Raumtemperatur abgekühlt und entnommen.

Während der gesamten Prozessführung kommt es zu keiner Umkehrung der Richtung des vorherrschenden Temperaturgradienten in dem Schmelztiegel 2.

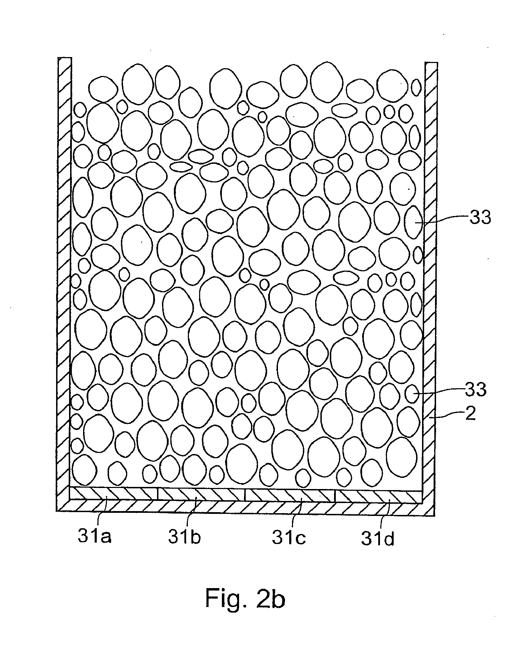

Die Figuren 2b bis 2d zeigen weitere Varianten zur Befüllung des Schmelztiegels mit einer Si-Schüttung bei einem Verfahren gemäß der vorliegenden Erfindung. Gemäß der Fig. 2b ist der gesamte Schmelztiegel 2 bis zum oberen Rand gleichmäßig mit einer groben Silizium-Schüttung 33, wie vorstehend beschrieben, aufgefüllt. Entsprechend der Fig. 2a ist auch gemäß der Fig. 2b der Boden des Schmelztiegels 2 mit einer Mehrzahl von Keimkristallplatten 31a-31d aus monokristallinem Silizium bedeckt.

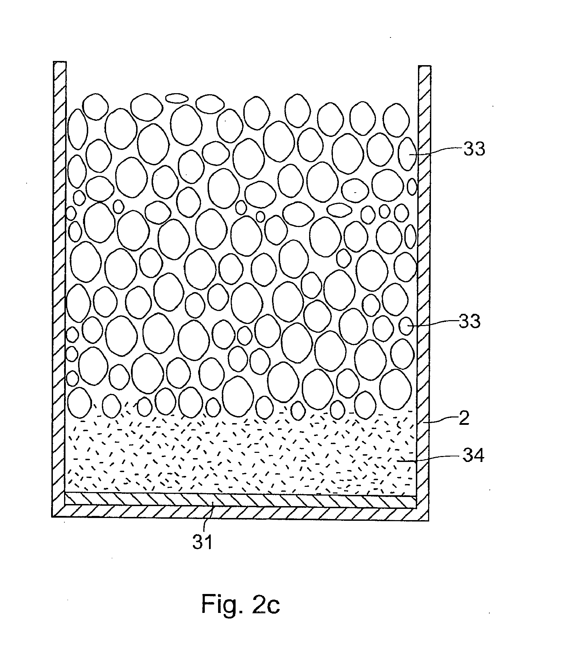

Die Befüllung des Schmelztiegels gemäß der Fig. 2c erfolgt grundsätzlich so, wie vorstehend anhand der Fig. 2a beschrieben. Abweichend ist der gesamte Boden des Schmelztiegels mit einer einzelnen, vergleichsweise dünnen Keimkristallplatte 31 aus monokristallinem Silizium bedeckt, welche auch die Eckbereiche des Schmelztiegels 2 ausfüllt.

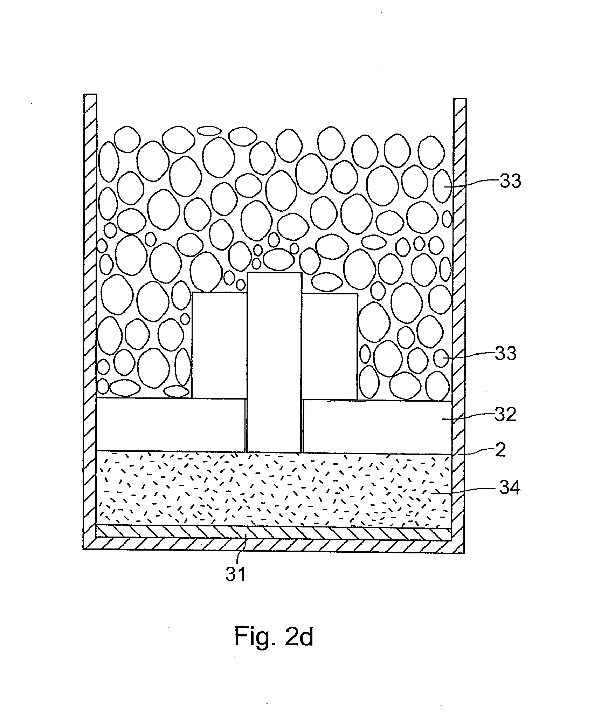

Gemäß der Fig. 2d ist der Boden des Schmelztiegels mit einer einzelnen, vergleichsweise dünnen Keimkristallplatte 31 aus monokristallinem Silizium bedeckt. Darüber ist ein Si-Granulat 34 mittlerer oder feiner Körnung eingebracht. Anschließend werden vergleichsweise große regelmäßig geformte Silizium-Körper 32 in horizontaler und vertikaler Erstreckung in den Tiegel eingebracht, wobei sich diese Körper 32 bevorzugt von der Mitte bis hin zu den Innenwänden des Tiegels sowie von der Mitte bis hin zum oberen Rand des Tiegels erstrecken. Diese Körper 32 sind entweder qualitativ verwendbare Restabschnitte eines Si-Ingots einer vorherigen Charge oder auch bezogener Rohstoff, der eine solche Geometrie aufweist (z.B. walzenförmige Stücke). Aufgrund der im Vergleich zu der Schüttung aus stückigem Silizium höheren Wärmeleitfähigkeit der Si-Körper 32 werden so Wärmebrücken im Inneren der Si-Schüttung geschaffen und kann Wärme gezielt in die Mitte und in die unmittelbare Nähe des Bodens des Behälters eingeleitet werden. Da beim Aufschmelzen die Wärme hauptsächlich von dem Deckelheizer und dem Mantelheizer zur Verfügung gestellt wird, kann die Si-Schüttung insgesamt gleichmäßiger aufgeschmolzen werden. Die Körper 32 sollten, so sie durch Abtrennen von einen Si-Ingot einer vorherigen Charge stammen, zuvor einer Reinigung (typischerweise ein Ätzprozess), der auch als Recyclingprozess bezeichnet wird, unterzogen werden, um wieder verwendbar zu sein.

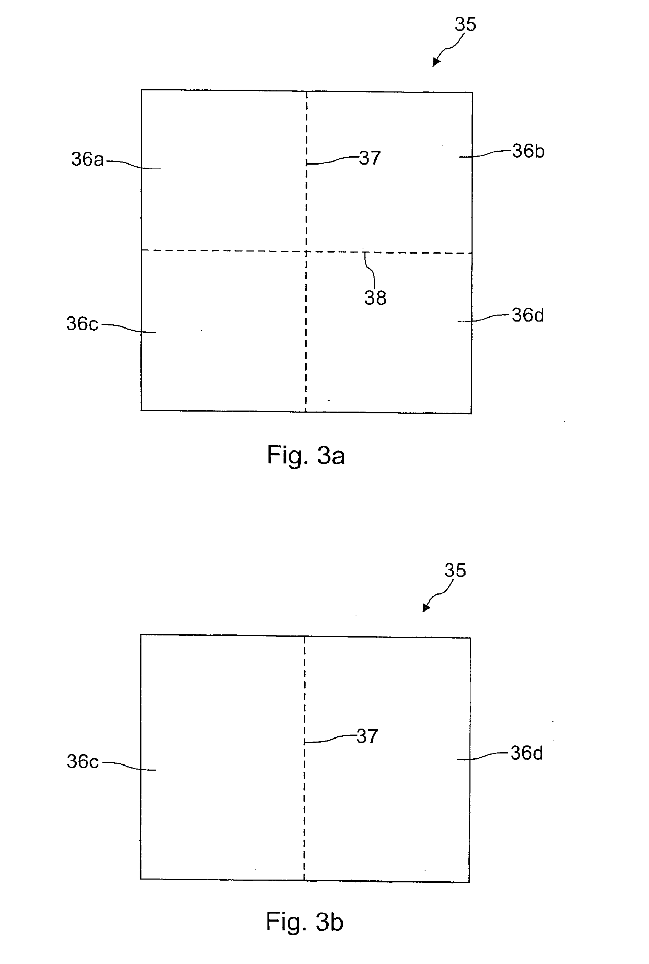

Die Fig. 3a zeigt die Anordnung der Keimkristallplatten 31a-31d in dem Schmelztiegel in einer Draufsicht bei einem Verfahren gemäß einer ersten Ausführungsform der vorliegenden Erfindung. Erkennbar ist, dass die Kanten der vier Keimkristallplatten 31a-31d unmittelbar aneinander anstoßen, sodass der Boden des Schmelztiegels vollständig bedeckt ist, auch in dessen Eckbereichen. Die Linien 37 und 38 bezeichnen in Draufsicht Sägelinien, entlang denen der Si-Ingot mit quadratischem Querschnitt nach dem Erstarren in vier kleinere, quadratische Blöcke mit identischen Grundflächen unterteilt wird, beispielsweise durch Sägen mittels einer Drahtsäge. Natürlich können je nach Größe des Ingots durch entsprechendes Sägen mittels Drahtsäge auch mehrere quadratische Blöcke entstehen (z.B. 25 5"-Blöcke oder 16 6"-Blöcke oder entsprechend der Grundfläche des Ingots andere Stückzahlen). Wie der Fig. 3a entnommen werden kann, verlaufen die Sägelinien exakt entlang den Kanten der Keimkristallplatten 31 a-31 d bzw. bei Verwendung größerer Keimkristallplatten innerhalb des monokristallin gewachsenen Ingotvolumens. Auf diese Weise werden die in einer horizontalen Schnittebene des Ingots bzw. der Blöcke detektierbaren Versetzungen erheblich reduziert. Die Wachstumsrichtung der Versetzungen ist typischerweise vertikal entsprechend der Bewegungsrichtung der Phasengrenze während der Kristallisation. Die Fig. 3b zeigt den Verlauf der Sägelinie 37 durch den monokristallinen Silizium-Ingot 35 in einer schematischen Seitenansicht. Dieses Verfahren wird bevorzugt bei einem Schmelztiegel der Abmessungen 720 x 720 mm (Höhe: z.B. 450 mm) eingesetzt, sodass durch Sägen entlang der Sägelinien 37, 38 unter Einrechnung von ausreichend Verschnitt Wafer mit sechs inches Kantenlänge entstehen.

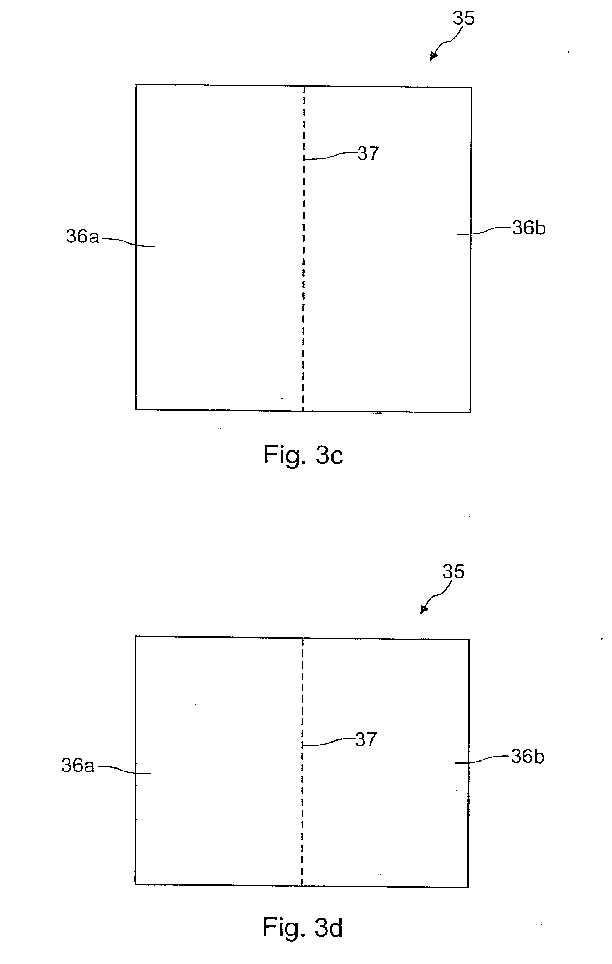

Die Fig. 3c zeigt die Anordnung der Keimkristallplatten 31a-31d in dem Schmelztiegel in einer Draufsicht bei einem Verfahren gemäß einer zweiten Ausführungsform der vorliegenden Erfindung. Erkennbar ist, dass die Kanten der beiden Keimkristallplatten 31 a-31b unmittelbar aneinander anstoßen, sodass der Boden des Schmelztiegels vollständig bedeckt ist, auch in dessen Eckbereichen. Die Linien 37 bezeichnet in Draufsicht Sägelinien, entlang der der Si-Ingot mit quadratischem Querschnitt nach dem Erstarren in zwei kleinere, rechteckförmige Blöcke mit identischen Grundflächen unterteilt wird, beispielsweise durch Sägen mittels einer Drahtsäge. Wie der Fig. 3c entnommen werden kann, verläuft die Sägelinie 37 exakt entlang den Kanten der Keimkristallplatten 31a-31b. Auf diese Weise werden die in einer horizontalen Schnittebene des Ingots bzw. der Blöcke detektierbaren Versetzungen erheblich reduziert. Die Wachstumsrichtung der Versetzungen ist typischerweise vertikal entsprechend der Bewegungsrichtung der Phasengrenze während der Kristallisation. Die Fig. 3d zeigt den Verlauf der Sägelinie 37 durch den monokristallinen Silizium-Ingot 35 in einer schematischen Seitenansicht. Dieses Verfahren wird bevorzugt bei einem Schmelztiegel der Abmessungen 720 x 720 mm (Höhe: z.B. 450 mm) eingesetzt, sodass durch Sägen entlang der Sägelinie 37 und einer Mittelsenkrechten dazu unter Einrechnung von ausreichend Verschnitt Wafer mit sechs inches Kantenlänge entstehen.

Die vorstehend beschriebenen vergleichsweise dünnen, monokristallinen Keimkristallplatten können in unterschiedlicher Weise hergestellt werden. So können diese beispielsweise aus einem in einem Verfahren nach Czochralski hergestellten monokristallinen Rohling herausgeschnitten werden, die mit Durchmessern von 300 bis 450 mm und Längen von bis zu 1000 mm mit Wachstumsrichtung in 111-Richtung oder 110-Richtung gezogen werden können. Da solchermaßen hergestellte Rohlinge üblicherweise einen kreisförmigen Querschnitt aufweisen, ist der Verschnitt bei dem Herausschneiden von rechteckförmigen oder quadratischen Keimkristallplatten vergleichsweise groß.

Kostengünstiger ist somit die Herstellung der Keimkristallplatten durch Abtrennen aus einem monokristallinen Si-Ingot aus einer vorherigen Charge, der nach dem erfindungsgemäßen Verfahren durch gerichtetes Erstarren hergestellt ist. Dabei kann der Boden des hierzu verwendeten weiteren Schmelztiegels mit einer Mehrzahl von Keimkristallplatten vollständig bedeckt werden, ganz besonders bevorzugt mit zwei oder vier Keimkristallplatten mit identischen Abmessungen, bevor das zu schmelzende Ausgangsmaterial, oder gemäß einer weiteren Variante, die gerichtet zu erstarrende Schmelze eingebracht wird. Die Ränder der Keimkristallplatten geben nach dem gerichteten Erstarren den Beginn der Sägelinien vor, entlang denen die nachfolgend zu verwendenden Keimkristallplatten abgetrennt werden.

Gemäß einer bevorzugten Ausführungsform der vorliegenden Erfindung wird die in dem weiteren Schmelztiegel gerichtet erstarrte Keimkristallplatte jedoch nicht in kleiner Keimkristallplatten zersägt sondern als Keimkristallplattenvorrat belassen, von dem bei Bedarf dünnere Keimkristallplatten durch Sägen in einer Richtung senkrecht zur Kristallisationsrichtung bzw. vertikalen Richtung des weiteren Schmelztiegels abgetrennt werden, beispielsweise mit einer Dicke von 30 mm. Eine solche Keimkristallplatte weist somit dieselbe Querschnittsfläche auf wie der in der nachfolgend hergestellten Charge verwendete Schmelztiegel. Da zur Ausbildung dieser Keimkristallplatten durch gerichtetes Erstarren jedoch mehrere Keimkristallplatten verwendet wurden, die unmittelbar aneinander anliegen, sind in dieser Keimkristallplatte entlang den Rändern der mehreren Keimkristallplatten jeweils Versatzlinien (dislocation lines) ausgebildet. Bei Verwendung dieser Keimkristallplatten mit zumindest einer Versatzlinie werden zum gerichteten Erstarren in einer nachfolgenden Charge werden in den Ingot dann eine entsprechende Anzahl von Versatzlinien hervorgerufen, entlang denen der Ingot dann in kleinere Blöcke zerlegt wird.

Dabei kann vom Ingot einer vorherigen Charge insbesondere auch eine Keimkristallplatte abgetrennt werden, die relativ stark verunreinigt ist. Herkömmlich werden von Ingots solche Randplatte abgetrennt und nicht weiter genutzt. Diese können jedoch für das erfindungsgemäße Verfahren grundsätzlich verwendet werden, was erhebliche Kostenvorteile nach sich zieht. Da solche verunreinigten Randplatten herkömmlich durchaus eine beträchtliche Stärke aufweisen, können so nahezu kostenfrei Keimkristallplatten mit beträchtlichen Dicken zur Herstellung von monokristallinen Ingots verwendet werden. Dabei ist selbstverständlich darauf zu achten, dass durch Verwendung der verunreinigten Randplatten als monokristalline Keimkristallplatten die Konzentration an Verunreinigungen innerhalb eines akzeptablen Bereichs bleibt.

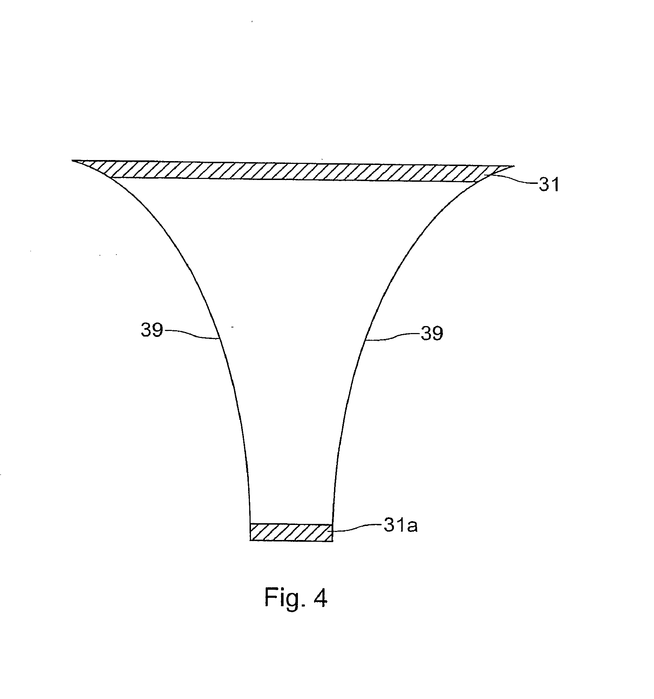

Um das gerichtete Erstarren eines großvolumigen Si-Ingots aus einer vergleichsweise kleinen Keimkristallplatte nach dem erfindungsgemäßen Verfahren zur Herstellung einer größeren Keimkristallplatte zu ermöglichen, kann dieses Verfahren auch dahingehend modifiziert werden, dass gemäß der Fig. 4 der Temperaturgradient während des gerichteten Erstarrens eine konvexe Phasengrenze (nicht dargestellt) zwischen flüssigem und festem Aggregatszustand bedingt ist, sodass der Querschnitt des beim gerichteten Erstarren entstehenden monokristallinen Kernbereichs sich in Richtung zu dem oberen Ende des weiteren Schmelztiegels verbreitert, wie schematisch in der Fig. 4 dargestellt. Gemäß der Fig. 4 beginnt das Verfahren mit dem Aufbringen einer vergleichsweise kleinen monokristallinen Keimkristallplatte 31 a, die im Zentrum des weiteren Schmelztiegels auf dessen Boden gelegt wird. Anschließend wird eine Si-Schüttung eingebracht, wie vorstehend beschrieben, diese aufgeschmolzen und nach dem vorstehend beschriebenen modifizierten Verfahren gerichtet erstarrt. Die Einhüllenden 39 bezeichnen den Grenzbereich zwischen zentraler monokristalliner Phase und angrenzender multikristalliner Phase in dem entstehenden Si-Ingot. Diese Grenzlinien wandern zum oberen Rand des weiteren Schmelztiegels immer mehr auseinander. Die bei einer nachfolgenden Charge zu verwendende Keimkristallplatte 31 a wird in der Nähe des oberen Endes des Si-Ingots, innerhalb des monokristallinen Bereichs, abgetrennt und weist die gleiche Fläche auf wie der zum gerichteten Erstarren verwendete Schmelztiegel. Der Ingot der nächsten Charge wird als Keimkristallplattenvorrat für alle nachfolgenden Chargen verwendet und weist die gleiche Grundfläche auf wie der zum gerichteten Erstarren verwendete Schmelztiegel.

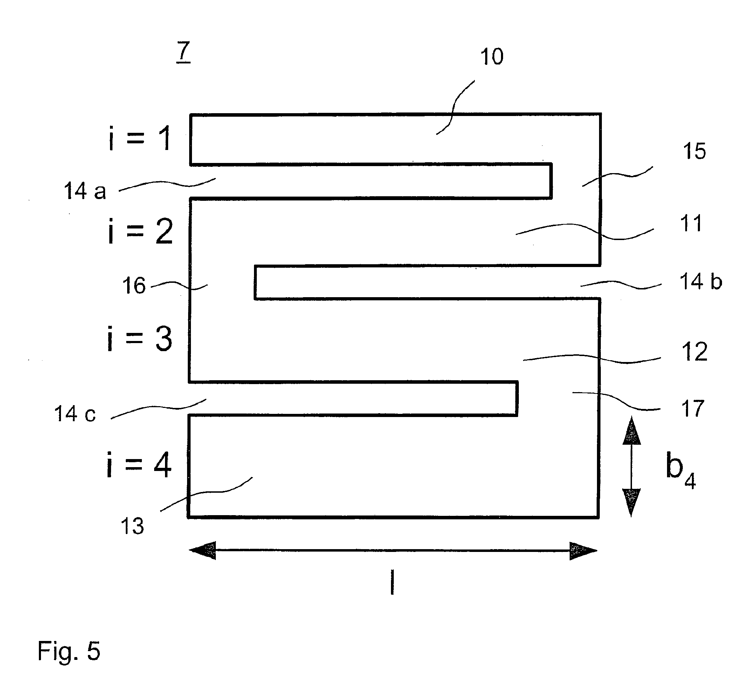

Nachfolgend werden anhand der Figuren 5 bis 7 weitere Maßnahmen gemäß der vorliegenden Erfindung beschrieben werden, die die Ausbildung von ebenen Isothermen in den Eckbereichen des vieleckigen, insbesondere rechteckförmigen oder quadratischen, Schmelztiegels während des gerichteten Erstarrens der Schmelze weiter unterstützen.

Die Fig. 5 zeigt ein Mantelheizersegment gemäß einer ersten Ausführungsform der vorliegenden Erfindung, der aus einer Mehrzahl von Heizstegen mit rechteckförmigem Profil ausgebildet ist, die in Längsrichtung des Tiegels einen mäanderförmigen Verlauf ausbilden. Genauer gesagt ist jedes Mantelheizersegment gemäß der Fig. 5 unter konstantem Abstand zu einer Tiegelwand angeordnet, so dass die Stege 10-13 sich exakt horizontal, senkrecht zur Längsrichtung des Tiegels, erstrecken. Die Verlaufsrichtung der Stege 10-13 kehrt an den Umkehrbereichen 15-17 um. Gemäß der Fig. 5 nimmt der Querschnitt der Stege 10-13 vom oberen Ende zum unteren Ende des Tiegels hin in diskreten Schritten zu. Die Heizleistung des obersten Stegs 10 ist somit am höchsten und nimmt in diskreten Schritten, wie durch die Leiterquerschnitte der Stege 11, 12 vorgegeben, zu der durch den Querschnitt des untersten Stegs 13 vorgegebenen niedrigsten Heizleistung ab.

Bei einer alternativen Ausführungsform (nicht gezeigt) sind die Breiten der Stege 10-13 konstant, nimmt jedoch deren Dicke, senkrecht zur Zeichenebene der Fig. 5 betrachtet, in diskreten Schritten vom oberen Ende zum unteren Ende des Tiegels hin zu.

Durch einen Mantelheizer, der aus mehreren Mantelheizersegmenten besteht, fließt ein Konstantstrom. Dabei definieren die horizontal verlaufenden Stege 10, 11, 12 und 13 Isothermen, die sich über die gesamte Breite des Tiegels erstrecken. Um den Umfang des Tiegels herum sind unter jeweils gleichen Abständen mehrere solcher Mantelheizer gemäß der Fig. 5 angeordnet, so dass die durch die Stege 10-13 festgelegten Isothermen sich über den gesamten Querschnitt des Tiegels erstrecken, um so ebene, horizontale Isothermenflächen vorzugeben.

Wenngleich in der Fig. 5 dargestellt ist, dass der Mantelheizer 7 insgesamt vier Querstege aufweist, können erfindungsgemäß beliebige andere Anzahlen von Heizstegen verwendet werden. Die optimale Anzahl von Heizstegen ergibt sich aus der gewünschten Vergleichmäßigung des Temperaturprofils im Tiegel und an der Tiegelwand. Zur Auslegung des Mantelheizers geht dabei insbesondere die Breite der Spalte 14a-14c zwischen den Stegen 10-13, der gewählte Abstand des Mantelheizers 7 zur Tiegelwand und die thermischen Eigenschaften der Tiegelwand ein. Der gut wärmeleitende Graphittiegel 4 (vgl. Fig. 1) mit ausreichender Stärke und der darin befindliche Quarztiegel führen dabei zu einer gewissen Glättung des vertikalen Temperaturprofils. Vorstehende Parameter werden so gewählt, dass die Position eines Stegs des Mantelheizers am Temperaturprofil an der Grenzfläche Silizium/seitliche Innenwand des Quarztiegels im Wesentlichen nicht mehr feststellbar ist.

Allgemein gilt bei dem Mantelheizer gemäß der Fig. 5 mit einer Länge der Stege 1, einer Breite der Stege $b_i$ (wobei i den laufenden Index des Stegs bezeichnet) und einer Dicke d (senkrecht zur Zeichenebene der Fig. 2), dass der elektrische Widerstand eines Heizstegs mit dem Index i gegeben ist durch:

$$Ri \sim l/Ai,$$

wobei

$$Ai = bi \times d.$$

Für die Querschnittflächen gilt dann:

$$A1 < A2 < A3 < A4.$$

Daraus folgt für die Widerstände der Einzelmäander R1 < R2 < R3 < R4.
Somit folgt:

$$T1 > T2 > T3 > T4.$$

Es ergibt sich also in vertikaler Richtung ein Temperaturprofil mit nach oben hin in diskreten Schritten zunehmender Temperatur. Bei Durchströmung des Heizmäanders mit einer konstanten Stromstärke wird in den Stegen mit großem Querschnitt (entsprechend einem geringen elektrischen Widerstand) eine niedrigere Temperatur erzeugt als in den Stegen mit kleinem Querschnitt (entsprechend einem großen Widerstand).
Wie dem Fachmann ohne weiteres ersichtlich sein wird, kann die Variation des stromdurchflossenen Leiterquerschnitts von Steg zu Steg auch durch Variation der Stegdicke d anstelle der Stegbreite b, wie vorstehend beschrieben, erzielt werden.
Bei einem Ausführungsbeispiel gemäß der Fig. 5 werden folgende Flächenverhältnisse eingestellt:

| A1/A1 | 1 |
|---|---|
| A2/A1 | 1,055 |
| A3/A1 | 1,11 |
| A4/A1 | 1,165 |

Aus diesen Flächenverhältnissen ergeben sich folgende Widerstandsverhältnisse:

| R1/R1 | 1 |
|---|---|
| R2/R1 | 0,948 |
| R3/R1 | 0,901 |
| R4/R1 | 0,858 |

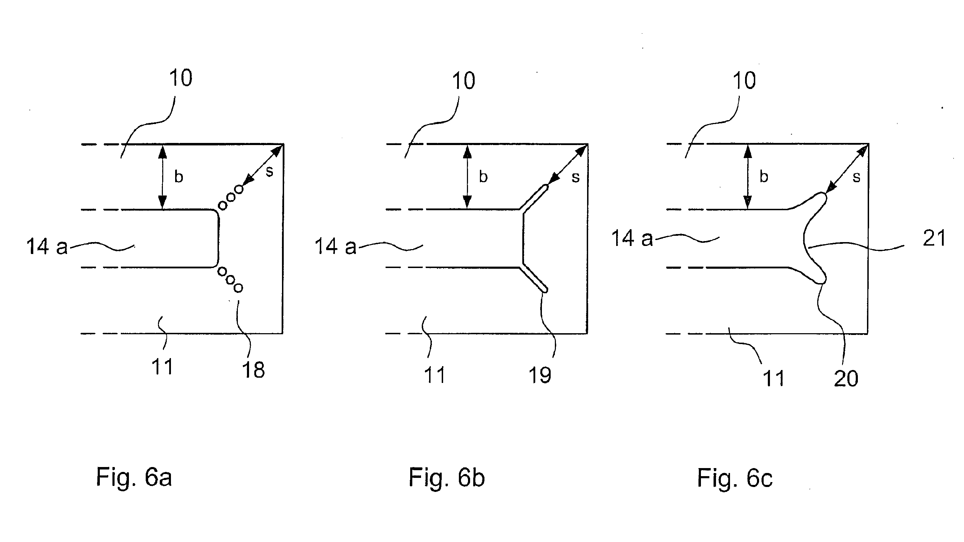

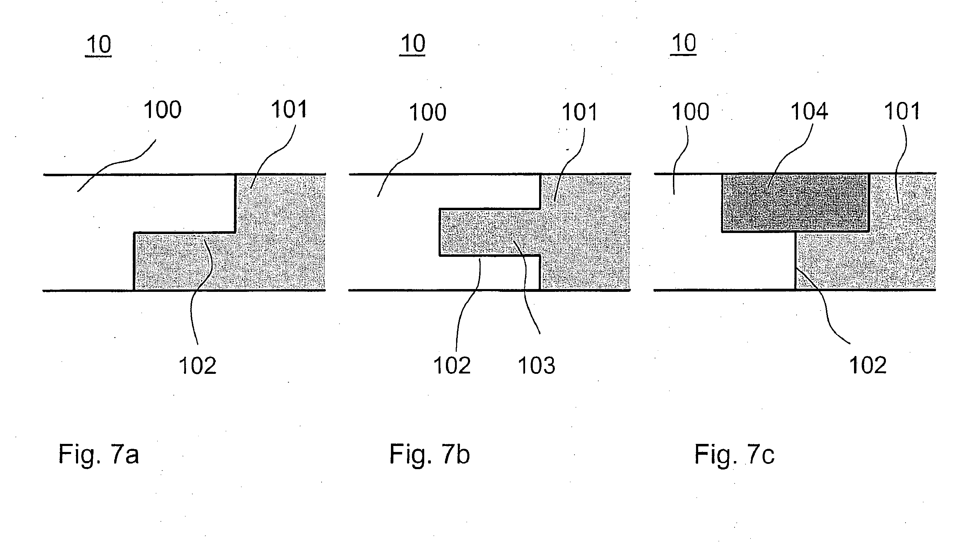

Wie in der Fig. 5 erkennbar, variiert die Breite des Heizleiters auch in den Umkehrbereichen 15 bis 17 in entsprechender Weise. Die Breite des Umkehrbereichs 15 ist somit kleiner als die Breite des Umkehrbereichs 16, die wiederum kleiner ist als die Breite des Umkehrbereichs 17. Die Variation der Breiten der Umkehrbereiche folgt dem auszubildenden Temperaturprofil.
Betrachtet man die Umkehrbereiche 15-17 des Mantelheizers 7 gemäß der Fig. 5, so treten dort lokale Querschnittsvergrößerungen des stromdurchflossenen Materials auf. Diese würden ohne Gegenmaßnahmen zu einer niedrigen Temperatur an den Eckbereichen des Tiegels führen. Dem wird erfindungsgemäß durch eine gezielte Verengung des Leiterquerschnitts in den Umkehrbereichen entgegengewirkt. Insbesondere können durch eine solche Verengung des Leiterquerschnitts auch erhöhte Wärmeverluste in den Eckbereichen des Tiegels, beispielsweise aufgrund höherer Wärmestrahlungsverluste bedingt durch die je Volumeneinheit größere abstrahlende Fläche, kompensiert werden.
Gemäß der Fig. 6a sind entlang den Diagonalen des jeweiligen Umkehrbereichs eine Mehrzahl von Lochungen oder Ausnehmungen 18 angeordnet, und zwar auf der Diagonalen fluchtend. Insgesamt sind die Lochungen bzw. Ausnehmungen 18 spiegelsymmetrisch zur Mittellinie des Spalts 14a angeordnet. Selbstverständlich können in dem Umkehrbereich auch mehrere solcher Reihen von Lochungen bzw. Ausnehmungen vorgesehen sein. Durch Auslegung und Wahl der Anzahl Lochungen bzw. Ausnehmungen kann das Widerstandsverhältnis zwischen dem sich in horizontaler Richtung erstreckenden Steg 10, 11 und dem zugeordneten Umkehrbereich geeignet eingestellt werden.
Bei der Ausführungsform gemäß der Fig. 6b sind entlang der Diagonalen rechteckförmige Ausnehmungen ausgebildet. Durch Wahl des Verhältnisses s/b kann ein optimales Widerstandsverhältnis eingestellt werden.
Gemäß der Fig. 6c sind entlang der Diagonalen sich verengende Ausnehmungen ausgebildet, wobei zwischen den Ausnehmungen 20 ein konkav einwärts gewölbter Randverlauf ausgebildet ist. Die vorstehenden Ausnehmungen 11, 20 können insbesondere durch Fräsen aus dem Material des Heizleiters ausgebildet werden.
Bevorzugt werden die Stege des Mantelheizers aus Graphit hergestellt. Da erfindungsgemäß Tiegel mit eine Grundfläche von 720 x 720 mm oder noch größere Tiegel verwendet werden, entsprechend große Graphitblöcke zur Herstellung der Stege des Mantelheizers entweder gar nicht verfügbar sind oder nur zu einem vergleichsweise hohen Preis, werden die Stege des Mantelheizersegments gemäß einer weiteren Ausführungsform, wie nachfolgend ausführlich anhand der Fig. 7a bis 7d beschrieben, aus wiederum einer Mehrzahl kleinerer Segmente gebildet. Dabei ist auf einen weitestgehend ungehinderten Stromfluss durch die Verbindungsstellen zwischen den Mantelheizersegmenten als auch zwischen den kleineren Segmenten zu achten. Hierzu werden formschlüssig ineinander eingreifende Verbindungsflächen mit rechtwinkliger Geometrie verwendet.
Gemäß der Fig. 7a sind die Enden der Heizsegmente 100, 101 im Wesentlichen L-förmig ausgebildet, so dass zwischen beiden Segmenten 100, 101 eine gestufte Grenzfläche 102 ausgebildet ist. Gemäß der Fig. 7b ist am Ende des Segments 100 eine zentrale U-förmige Ausnehmung ausgebildet und ist am gegenüberliegenden Ende des Segments 101 ein korrespondierender invers U-förmiger Vorsprung 103 ausgebildet, der in die Ausnehmung des Segments 100 eng anliegend angepasst ist. Somit wird zwischen den Segmenten 100, 101 eine Grenzfläche 102 mit einem zentralen Vorsprung ausgebildet. Gemäß der Fig. 7c ist an den Enden der Segmente 100, 101 eine quaderförmige Ausnehmung ausgebildet, zur Aufnahme eines Verbindungselements 104.

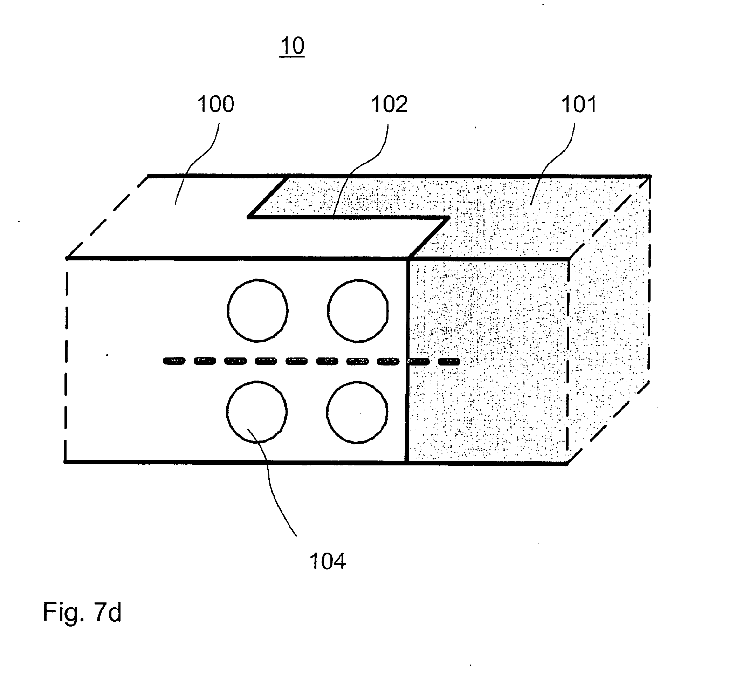

Die Fig. 7d zeigt die Verbindung gemäß der Fig. 7a in einer perspektivischen Draufsicht, wobei die Segmente 100, 101 von zylindrischen Verbindungselementen 104 durchgriffen werden. Die Verbindungselemente 104 können aus dem Material der Segmente 100, 1001 ausgebildet sein. Die Verbindungselemente 104 können form-, reib- oder kraftschlüssig in die Segmente 100, 101 eingreifen. Die Verbindungselemente 104 können alternativ auch aus einem anderen Material mit einem identischen oder geringfügig größeren Wärmeausdehnungskoeffizienten als dem Material der Segmente 100, 101 ausgebildet sein.

Gemäß einer von den Erfindern durchgeführten Versuchsreihe wurden zwei quaderförmige Heizersegmente aus Graphit in der Art gemäß der Fig. 7d miteinander verbunden und ein Temperaturprofil entlang der gestrichelten Linie gemäß der Fig. 7d ortsaufgelöst aufgenommen. Aus Korrosionsgründen wurden die Messungen in normaler Luftatmosphäre und bei tieferer Temperatur als der späteren Einsatztemperatur unter Stromdurchfluss vorgenommen. Die gemessene Gleichmäßigkeit des Temperaturprofils auf diesem niedrigeren Temperaturniveau ist jedoch vollständig übertragbar auf das spätere höhere Einsatztemperaturniveau.

Die erzielbaren Temperaturschwankungen im Verbindungsbereich sind von der Größenordnung von kleiner als etwa $\pm$ 5° Celsius.

**Ausführungsbeispiel**

Zur Herstellung eines monokristallinen Silizium-Ingots wurde ein Quarztiegel mit einer quadratischen Grundform der Abmessungen 720 x 720 mm und einer Höhe von 450 mm verwendet. Der Boden des Schmelztiegels wurde mit einer vier einzelne Keimkristallplatten umfassenden Keimkristallplattenschicht mit Kristallrichtung parallel zu den Seitenwänden des Schmelztiegels bedeckt. Die Keimkristallplatten wurden von einem nach dem Czochralski-Verfahren hergestellten Si-Einkristall abgetrennt. Auf diese Keimkristallplattenschicht wurde dann ein Silizium-Granulat feiner oder mittlerer Körnung bis zum oberen Rand des Schmelztiegels nachgefüllt. Das Si-Granulat wurde von oben her durch einen Deckelheizer aufgeschmolzen. Dabei waren die Mantelheizer ebenfalls eingeschaltet, während der Boden des Schmelztiegels nicht beheizt wurde. Es wurde mit einer Abschmelzrate von 5 cm/h gearbeitet, die gemäß anderen Versuchsreihen im Bereich zwischen 1 cm/h und 10 cm/h variiert werden konnte. Beim Aufschmelzen wurde die Phasengrenze fest/flüssig zuerst über den Tiegel von oben nach unten abgesenkt, bis das Anschmelzen der Keimkristallplatte erreicht wurde. Dabei war der Wärmeeintrag von oben her vergleichsweise groß während die Wärmeverluste am Boden des Schmelztiegels relativ gering waren, um so ein geeignet rasches, energieeffizientes Aufschmelzen zu ermöglichen.

In einem zweiten Schritt wurde die Wärmeabfuhr am Boden des Schmelztiegels erhöht und gleichzeitig der Wärmeeintrag von oben her herabgesetzt. Dadurch wird die Bewegungsrichtung der Phasengrenze fest/flüssig wieder umgekehrt. Es konnte die gerichtete Erstarrung eines monokristallinen Si-Ingots beobachtet werden, dessen kristalline Struktur durch die der Keimkristallplatten vorgegeben war. Dabei entscheidet das Verhältnis zwischen Wärmeeintrag von oben her und Wärmeabfuhr am Boden des Schmelztiegels über die Erstarrungsgeschwindigkeit.

Durch geeignete Formgebung des Mantelheizers im Bereich der Umkehrbereiche seiner mäanderförmig verlaufenden Heizstege, wie vorstehend anhand der Figuren 5 bis 7 beschrieben, konnten ebene Isothermen insbesondere auch in den Eckbereichen des Schmelztiegels eingestellt werden.

Der so erhaltene Si-Ingot wurde entlang von Sägelinien, die entlang den Rändern der zum gerichteten Erstarren verwendeten Keimkristallplatten und senkrecht zur Kristallisationsrichtung verlaufen, in eine der Anzahl von Keimkristallplatten entsprechende Anzahl von Si-Blöcken zerlegt, die sich jeweils durch eine geringe mittlere Versetzungsdichte aufgrund des geringen bzw. fehlenden seitlichen Temperaturgradienten auszeichneten.

Die mittlere Versetzungsdichte der Si-Wafer wurde durch sog. "Versetzungsätzen" bestimmt. Dazu wird eine beliebig orientierte, eben polierte und gereinigte Si-Probe eines Wafers(beispielsweise der Größe 30x30x2 mm) mit Hilfe einer sog. "Secco"-Ätze (Ätzansatz: 4,4g $K_2Cr_2O_7$ in 100ml Wasser lösen, sobald das $K_2Cr_2O_7$ vollständig aufgelöst ist, 200ml 48%-tige Flusssäure hinzugeben) 20 bis 60 Sekunden angeätzt. Alternativ kann die polierte Waferfläche auch durch ein bekanntes Glanzätzen des Wafers erreicht werden. An den Durchstoßpunkten der Versetzungslinien durch die Oberfläche entstehen dadurch charakteristische Ätzgruben. Die Dichte der Ätzgruben auf der Oberfläche (etch pit density / EPD), die in $1/cm^2$ angegeben wird und ein übliches Maß für die Versetzungsdichte eines Materials darstellt, wird unter einem Lichtmikroskop ermittelt, indem über die gesamte Fläche der Probe in Ausschnitten von z.B. 300x300 $\mu$m die Anzahl der Ätzgruben gezählt wird und in die Flächendichte umgerechnet wird. Die mittlere Versetzungsdichte eines Wafers wird als Mittelwert über alle ausgezählten Flächen der Waferproben und der Flächenausschnitte der Proben angegeben, d.h. gemittelt über die gesamte untersuchte Fläche des Wafers. Es konnte pro Wafer eine mittlere Versetzungsdichte, d.h. ein Mittelwert der Versetzungsdichte, von weniger als $1x10^5$ $cm^{-2}$ an nach dem erfindungsgemäßen VGF-Verfahren hergestellten Kristallen und daraus hergestellten Wafern gemessen werden, und zwar gemittelt im Wesentlichen über die gesamte Fläche der gereinigten und polierten Proben eines jeden Wafers. Damit konnten monokristalline Si-Solarzellen mit einem Wirkungsgrad größer als 15,5%, größer als 16%, größer als 16,5%, ja größer als 17% hergestellt werden.

**Vergleichsbeispiel**

Mit Ausnahme der den Boden des Schmelztiegels bedeckenden Keimkristallplatten wurde der Schmelztiegel in identischer Weise befüllt. Anschließend wurde der Schmelztiegel in entsprechender Weise geheizt und wieder abgekühlt. Anschließend wurde der Si-Ingot entnommen und weiter untersucht, insbesondere im Hinblick auf die Versetzungsdichte, die wie vorstehend beschrieben bestimmt wurde.

Es ergab sich, dass eine mittlere Versetzungsdichte von weniger als $10^5$ cm$^{-2}$ nicht erreicht werden konnte. Damit konnten keine Si-Solarzellen mit einem Wirkungsgrad von größer 15,5% hergestellt werden.

**Weitere Ausführungsbeispiele**

Keimkristallplatten wurden von einem nach dem Czochralski-Verfahren in 110 (oder auch 111) gezogenen Si-Einkristall mit einem Durchmesser von 450mm durch Sägen entlang der Kristallisationsrichtung (Halbieren) und Nachbearbeitung der Kanten so, dass die beiden Keimkristallplatten Stoß an Stoß aneinander gelegt werden konnten, ausgebildet. Dadurch wurden zwei rechteckförmige Keimkristallplatten mit einer Dicke von 30 mm und einer Grundfläche von 410 x 820 mm ausgebildet, mit denen der Boden des Schmelztiegels vollständig bedeckt wurde. Der durch gerichtetes Erstarren ausgebildete Si-Ingot wurde als Keimkristallplattenvorrat verwendet, von dem eine einzelne Keimkristallplatte mit einer Grundfläche, die der Grundfläche des in nachfolgenden Chargen verwendeten Schmelztiegels entsprach, abgetrennt wurde. Entlang der Mitte dieser Keimkristallplatte verlief eine Versetzungslinie, die zu einer entsprechend verlaufenden Versetzungslinie in dem durch gerichtetes Erstarren ausgebildeten Si-Ingot führte.

Es konnte eine mittlere Versetzungsdichte, d.h. ein Mittelwert der Versetzungsdichte, von weniger als $1 \times 10^5$ cm$^{-2}$ an den so hergestellten Si-Kristallen und daraus hergestellten Wafern gemessen werden.

Die segmentierte mäanderförmige Heizergestaltung kann, wie dem Fachmann ohne weiteres ersichtlich sein wird, auch für die Heizer oberhalb und unterhalb des Tiegels verwendet werden. Eine Variation der stromdurchflossenen Querschnitte erfolgt bei diesen Heizern jedoch zweckmäßig nicht, da Oberseite und Unterseite des Silizium-Ingots möglichst gleichmäßig beheizt werden sollen. Der optional unter dem Tiegelboden vorgesehene Heizer unterstützt das Aufschmelzen von stückigem Silizium mit dem Ziel einer möglichst kurzen Prozesszeit. Während der Kristallisation wird der Heizer am Tiegelboden jedoch grundsätzlich nicht benötigt.

Die Heizergestaltung im Zusammenwirken mit der elektronisch gesteuerten Temperaturabsenkung bewirkt insbesondere die folgenden Vorteile:

➤ Die ebene Phasengrenze in allen Kristallisationsphasen bewirkt ein kolumnares, senkrechtes Wachstum der Si-Körner mit homogenem Gefüge;

➤ Geringe Anzahl von Liniendefekten im Ingot, feststellbar am Si-Wafer anhand einer geringeren Ätzgrubendichte;

➤ Minimierung der Konvektionsströmungen im noch schmelzflüssigen Si oberhalb der Phasengrenze und dadurch Minimierung des Transportes von Si$_3$N$_4$-Partikeln von der innenbeschichteten Quarztiegelwand in das Innere der Schmelze bzw. Minimierung des Transportes von SiC-Partikeln von der Oberfläche des schmelzflüssigen Si in das Innere der Schmelze, was beides zu verringerten Einschlüssen im Ingot führt; die Ausbeute und der Wirkungsgrad werden durch die vorgenannte Minierung erhöht;

➤ Verhinderung von Spannungen im Eckenbereich des Ingots und dadurch Vermeidung erhöhter Defektkonzentrationen in den Ecken, Vermeidung spannungsbedingter Mikrorisse, die ansonsten in späteren Bearbeitungsschritten zu Ausbeuteverlusten führen würden.

Ohne auf die zugrunde liegende Theorie beschränkt werden zu wollen, wird angenommen, dass die entlang den Rändern der Keimkristallplatten bzw. der Versetzungslinie der einzelnen Keimkristallplatte entstehende Versetzunglinie bzw. Versetzungslinien in dem Si-Ingot eine mittelgroße Versetzungsdichte im Bereich von weniger als $1 \times 10^5$ cm$^{-2}$ induziert bzw. induzieren, die sich als hervorragend geeignet zur Herstellung von Solarzellen mit hohem Wirkungsgrad erwies.

Wenngleich sich die Ausführungsbeispiele vorstehend überwiegend auf Tiegelhöhen von 450 mm bezogen haben, sei ausdrücklich darauf hingewiesen, dass Experimente ergeben haben, dass die Vorteile, die man durch die spezielle Gestaltung der Umkehrbereiche der mäanderförmig verlaufenden Heizstege des flächigen Mantelheizers erzielen kann, wie vorstehend beschrieben, ganz besonders für noch höhere Tiegelhöhen zum Tragen kommen, beispielsweise für Tiegelhöhen von 660 mm oder gar 760 mm, was auch die Herstellungskosten je Wafer weiter reduziert. Ferner haben Experimente ergeben, dass auch die Außenmaße des Schmelztiegels größer sein können, als vorstehend beschrieben, beispielsweise 720 mm, 880 mm oder 1040 mm betragen können.

**Bezugszeichenliste**

| | |
|---|---|
| 1 | Kristallisationsanlage |
| 2 | Quarztiegel |
| 3 | Schmelze |
| 4 | Graphittiegel |
| 5 | Bodenheizer |
| 6 | Deckelheizer |
| 7 | Mantelheizer / flächige seitliche Heizeinrichtung |
| 9 | Temperaturfühler |
| | |
| 10 | Horizontaler Steg |
| 11 | Horizontaler Steg |
| 12 | Horizontaler Steg |
| 13 | Horizontaler Steg |
| 14a-c | Spalt |
| 15 | Vertikaler Verbindungssteg |
| 16 | Vertikaler Verbindungssteg |
| 17 | Vertikaler Verbindungssteg |
| 18 | Bohrung/Ausnehmung |
| 19 | Ausnehmung |
| 20 | Ausnehmung |
| 21 | Rand |
| | |
| 31 | monokristalline Silizium-Platten |
| 31a - 31d | monokristalline Silizium-Platten |
| 32 | große, regelmäßig geformte Silizium-Körper |
| 33 | grobe Silizium-Stücke |
| 34 | Silizium-Granulat feiner oder mittlerer Körnung |
| | |
| 35 | monokristalliner Silizium-Ingot |
| 36a-36d | monokristalline Si-Blöcke |
| 37 | Sägelinie |
| 38 | Sägelinie |
| 39 | Begrenzungslinien des monokristallinen Bereichs |
| | |
| 40 | Isolationsschicht / Tiegelaufstellplatte |
| | |
| 100 | Erstes Segment |
| 101 | Zweites Segment |
| 102 | Grenzfläche |
| 103 | Zentraler Vorsprung |
| 104 | Verbindungselement |

**Patentansprüche**

1. Verfahren zur Herstellung eines monokristallinen Metall- oder Halbmetallkörpers durch gerichtetes Erstarren, wobei
ein Halbmetall- oder Metall-Ausgangsmaterial (32 - 34) in einem Schmelztiegel (2, 4) zu einer Schmelze (3) geschmolzen wird oder eine Halbmetall- oder Metallschmelze in den Schmelztiegel eingebracht wird,
die Schmelze unter Einwirkung eines Temperaturgradienten, der in einer vertikalen Richtung und vom oberen Ende des Schmelztiegels (2, 4) zu dessen unterem Ende zeigt, sowie in Gegenwart einer horizontalen Phasengrenze zwischen flüssigem und festem Zustand während der Erstarrung zu dem monokristallinen Metall- oder Halbmetallkörper gerichtet erstarrt wird,
vor dem Einbringen des Halbmetall- oder Metall-Ausgangsmaterials (32 - 34) oder der Schmelze in den Schmelztiegel (2, 4) der Boden des Schmelztiegels mit einer dünnen monokristallinen Keimkristallplattenschicht (31; 31a-31d; 36a-d; 36a-b) mit einer Kristallorientierung parallel zur vertikalen Richtung des Schmelztiegels (2, 4) vollständig bedeckt wird;
die Temperatur des Bodens des Schmelztiegels (2, 4) auf einer Temperatur unterhalb der Schmelztemperatur des Ausgangsmaterials (32 - 34) oder der Schmelzen gehalten wird, um ein Schmelzen der Keimkristallplattenschicht (31; 31a-31d; 36a-d; 36a-b) jedenfalls bis hinab zum Boden des Schmelztiegels (2, 4) zu verhindern; bei welchem Verfahren die dünne monokristalline Keimkristallplattenschicht eine Mehrzahl von dünnen monokristallinen Keimkristallplatten (31a-d; 31a-b) gleicher Größe umfasst, die unmittelbar aneinander angrenzend angeordnet werden, um den Boden des Schmelztiegels (2, 4) vollständig zu bedecken, oder eine einzelne monokristalline Keimkristallplatte umfasst, in welcher zumindest eine Versatzlinie ausgebildet ist, welche die einzelne monokristalline Keimkristallplatte in Keimkristallplattenunterabschnitte (31a-d; 36a-d; 36a-b) gleicher Größe unterteilt;
wobei der monokristalline Metall- oder Halbmetallkörper (35) durch Sägen entlang von zumindest einer sich parallel zur Kristallorientierung erstreckenden Sägelinie (37, 38) in eine Mehrzahl von monokristallinen Metall- oder Halbmetallkörper (35) unterteilt wird; und
der Beginn der jeweiligen Sägelinie (37, 38) so gewählt wird, dass dieser durch den Rand einer Keimkristallplatte (36a-d; 36a-b) oder durch eine jeweilige Versatzlinie innerhalb der einzelnen monokristallinen Keimkristallplatte festgelegt ist;
wobei eine den Schmelztiegel (2, 4) umgebende Heizeinrichtung einen Deckelheizer (6), einen Bodenheizer (5) und eine Seitenwände des Schmelztiegels (2, 4) umgebende flächige Heizeinrichtung (7) umfasst, wobei
die Heizleistung der flächigen Heizeinrichtung (7) während des gerichteten Erstarrens vom oberen Ende zum unteren Ende des Schmelztiegels (2, 4) hin in Entsprechung zum Temperaturgradienten im Zentrum des Schmelztiegels abnimmt; und
die flächige Heizeinrichtung (7) eine Mehrzahl von Heizelementen (10-13) umfasst, die in Längsrichtung des Schmelztiegels (2, 4) oder senkrecht dazu einen mäanderförmigen Verlauf aufweisen und die als sich senkrecht zur Längsrichtung erstreckende Stege (10-13) bereitgestellt werden, deren Leiterquerschnitte von dem oberen Ende zu dem unteren Ende hin in einer Mehrzahl von diskreten Schritten zunehmen;

wobei der Schmelztiegel (2, 4) einen rechteckförmigen oder quadratischen Querschnitt aufweist;

in Eckbereichen des Schmelztiegels (2, 4) die Heizleistung der flächigen Heizeinrichtung (7) höher ist oder ein Abstand zwischen einer Tiegelwand und der flächigen Heizeinrichtung (7) kleiner ist als in den übrigen Bereichen; und

die Stege (10-13) mit einem Leiterquerschnitt bereitgestellt werden, der an Umkehrbereichen (15-17) des mäanderförmigen Verlaufs verengt ist.

2. Verfahren nach Anspruch 1, wobei die jeweilige Keimkristallplatte (31; 31a-31d; 36a-d; 36a-b) von einem monokristallinen Metall- oder Halbmetallkörper abgetrennt wird, der durch gerichtetes Erstarren einer Schmelze in einem weiteren Schmelztiegel hergestellt wurde, wobei

vor dem Einbringen eines Halbmetall- oder Metall-Ausgangsmaterials (32 - 34) oder der Schmelze in den weiteren Schmelztiegel (2, 4) der Boden des weiteren Schmelztiegels mit einer dünnen monokristallinen Keimkristallplattenschicht (31; 31a-31d; 36a-d; 36a-b) mit einer Kristallorientierung parallel zur vertikalen Richtung des weiteren Schmelztiegels (2, 4) vollständig bedeckt wird; und

die Temperatur des Bodens des weiteren Schmelztiegels (2, 4) auf einer Temperatur unterhalb der Schmelztemperatur des Ausgangsmaterials (32 - 34) oder der Schmelze gehalten wird, um ein Schmelzen der Keimkristallplattenschicht (31; 31a-31d; 36a-d; 36a-b) jedenfalls bis hinab zum Boden des Schmelztiegels (2, 4) zu verhindern; wobei

die dünne monokristalline Keimkristallplattenschicht eine Mehrzahl von dünnen monokristallinen Keimkristallplatten (31a-d; 31a-b) gleicher Größe umfasst, die unmittelbar aneinander angrenzend angeordnet werden, um den Boden des Schmelztiegels (2, 4) vollständig zu bedecken, oder eine einzelne monokristalline Keimkristallplatte umfasst, in welcher zumindest eine Versatzlinie ausgebildet ist, welche die einzelne monokristalline Keimkristallplatte in Keimkristallplattenunterabschnitte (31a-d; 36a-d; 36a-b) gleicher Größe unterteilt.

3. Verfahren nach Anspruch 2, wobei der Temperaturgradient während des gerichteten Erstarrens der vorherigen Charge eine ebene, horizontale Phasengrenze zwischen flüssigem und festem Aggregatszustand des Halbmetalls oder Metalls bedingt.

4. Verfahren nach Anspruch 1, wobei zu Beginn der Herstellung der Keimkristallplatte nur ein kleiner mittlerer Abschnitt des Bodens eines weiteren Schmelztiegels (2, 4) mit einer dünnen monokristallinen Keimkristallplatte (31a) mit einer Kristallorientierung parallel zur vertikalen Richtung des Schmelztiegels (2, 4) bedeckt wird und der Temperaturgradient während des gerichteten Erstarrens einer Schmelze in dem weiteren Schmelztiegel eine konvexe Phasengrenze zwischen flüssigem und festem Aggregatszustand des Halbmetalls oder Metalls bedingt, sodass sich der Querschnitt des beim gerichteten Erstarren entstehenden monokristallinen Metall- oder Halbmetallkörpers in Richtung zu dem oberen Ende des weiteren Schmelztiegels vergrößert, wobei die einzelne monokristalline Keimkristallplatte (31 a) oder die Mehrzahl von monokristallinen Keimkristallplatten vom oberen Ende oder nahe dem oberen Ende des so hergestellten monokristallinen Metall- oder Halbmetallkörpers abgetrennt wird bzw. werden.

5. Verfahren nach Anspruch 1, wobei die jeweilige Keimkristallplatte (31; 31a-31d; 36a-d; 36a-b) dadurch hergestellt wird, dass

aus einem durch Zonenschmelzen nach oder durch ein Czochralski-Ziehverfahren hergestellten monokristallinen Metall- oder Halbmetallkörper zumindest zwei Keimkristallplatten (31a-31d; 36a-d; 36a-b) mit rechteckförmiger oder quadratischer Grundform abgetrennt werden,

der Boden eines weiteren Schmelztiegels mit den zumindest zwei Keimkristallplatten mit einer Kristallorientierung parallel zur vertikalen Richtung des weiteren Schmelztiegels (2, 4) vollständig bedeckt wird,

in dem weiteren Schmelztiegel ein Halbmetall- oder Metall-Ausgangsmaterial (32-34) zu einer Schmelze (3) geschmolzen wird oder in den weiteren Schmelztiegel eine Halbmetall- oder Metallschmelze eingebracht wird,

die Schmelze unter Einwirkung eines Temperaturgradienten, der in der vertikalen Richtung und vom oberen Ende des weiteren Schmelztiegels (2, 4) zu dessen unterem Ende zeigt, zu einem monokristallinen Metall- oder Halbmetallkörper gerichtet erstarrt wird, und

die jeweilige Keimkristallplatte (31; 31a-31d; 36a-d; 36a-b) von dem so gerichtet erstarrten monokristallinen Metall- oder Halbmetallkörper abgetrennt wird, wobei

die Temperatur des Bodens des weiteren Schmelztiegels (2, 4) auf einer Temperatur unterhalb der Schmelztemperatur des Ausgangsmaterials (32 - 34) oder der Schmelze gehalten wird, um ein Schmelzen der Keimkristallplattenschicht jedenfalls bis hinab zum Boden des weiteren Schmelztiegels (2, 4) zu verhindern.

**6.** Verfahren nach einem der Ansprüche 2 bis 5, wobei die jeweilige Keimkristallplatte (31; 31a-31d; 36a-d; 36a-b) von dem gerichtet erstarrten monokristallinen Metall- oder Halbmetallkörper durch Sägen in einer Richtung senkrecht zur vertikalen Richtung abgetrennt wird.

**7.** Verfahren nach Anspruch 6, wobei die jeweilige Keimkristallplatte (31; 31a-31d; 36a-d; 36a-b) ferner durch Sägen in einer Richtung parallel zur vertikalen Richtung abgetrennt wird, wobei der Beginn der jeweiligen Sägelinie (37, 38) so gewählt wird, dass dieser entweder durch den Rand einer Keimkristallplatte (36a-d; 36a-b) oder durch eine jeweilige Versatzlinie innerhalb der einzelnen monokristallinen Keimkristallplatte festgelegt ist.

**8.** Verfahren nach einem der vorhergehenden Ansprüche, wobei die Richtung des Temperaturgradienten sich während des Schmelzens des Halbmetall- oder Metall-Ausgangsmaterials in dem Schmelztiegel und während des gerichteten Erstarrens der Schmelze in dem Schmelztiegel niemals umkehrt.

**9.** Verfahren nach einem der vorhergehenden Ansprüche, wobei das Halbmetall Silizium ist und die Temperatur des Bodens des Schmelztiegels unterhalb von 1400 °C, bevorzugter unterhalb von 1380 °C gehalten wird.

**10.** Verfahren nach einem der vorhergehenden Ansprüche, wobei der Schmelztiegel (2, 4) einen rechteckförmigen oder quadratischen Querschnitt aufweist.

**11.** Verfahren nach einem der vorhergehenden Ansprüche, bei dem die Stege (10-13) an den Umkehrbereichen mit einem sich in Diagonalrichtung verengenden Leiterquerschnitt bereitgestellt werden, sodass der Leiterquerschnitt dem Leiterquerschnitt eines zugeordneten Stegs vor oder nach dem jeweiligen Umkehrbereich gleicht.

**12.** Verfahren nach Anspruch 11, bei dem die Verengungen des Leiterquerschnitts an den Umkehrbereichen (15-17) durch eine Mehrzahl von Lochungen oder Ausnehmungen in bzw. aus dem Stegmaterial ausgebildet werden, die quer zum Leiterquerschnitt verteilt ausgebildet sind.

**13.** Verfahren nach einem der vorhergehenden Ansprüche, bei dem das Halbmetall- oder Metall-Ausgangsmaterial stückiges, granulares Silizium ist, das vom oberen Rand des Schmelztiegels her aufgeschmolzen wird, sodass aufgeschmolzenes, flüssiges Silizium durch die Silizium-Schüttung nach unten läuft bzw. sickert, wobei zum Auffüllen des Schmelztiegels mit dem Ausgangsmaterial Silizium-Granulat (34), bevorzugt einer mittleren oder feinen Körnung, auf den mit der Keimkristallplattenschicht (31; 31a-31d; 36a-d; 36a-b) bedeckten Boden aufgebracht wird, das Silizium-Granulat (34) zunächst in einer dünnen Lage eingebracht wird und anschließend große Silizium-Platten (32) in horizontaler Ausrichtung, sodass diese sich jeweils von der Mitte des Schmelztiegels im Wesentlichen bis zu dessen Innenwänden erstrecken, und/oder vertikaler Ausrichtung eingebracht werden, sodass diese sich im Wesentlichen bis zum oberen Rand des Schmelztiegels erstrecken, die großen Silizium-Platten (32) von weiterem Silizium-Granulat (34) bedeckt werden, und die Silizium-Schüttung abschließend von kleineren Silizium-Stücken (33) bedeckt wird.

## Claims

**1.** A method for producing a monocrystalline metal or semi-metal body by directional solidification, wherein:

a semi-metal or metal raw material (32-34) is molten in a melting crucible (2, 4) to form a melt (3) or a semi-metal or metal melt is introduced into the melting crucible, the melt is directionally solidified under the action of a temperature gradient pointing in a vertical direction and from the upper end of the melting crucible (2, 4) to the lower end thereof and in the presence of a horizontal phase boundary between the liquid and solid state during the directional solidification to the monocrystalline metal or semi-metal body, prior to introducing the semi-metal or metal raw material (32-34) or of the melt into the melting crucible (2, 4) the bottom of the melting crucible is completely covered with a thin monocrystalline seed crystal plate layer (31; 31a-31d; 36a-d; 36a-b) having a crystal orientation parallel to the vertical direction of the melting crucible (2, 4); the temperature of the bottom of the melting crucible (2, 4) is kept at a temperature below the melting temperature of the raw material (32-34) or of the melt in order to prevent melting of the seed crystal plate layer (31; 31a-31d; 36a-d; 36a-b) in any case down to the bottom of the melting crucible (2, 4); in which method:

the thin monocrystalline seed crystal plate layer comprises a plurality of thin monocrystalline seed crystal plates (31a-31d; 31a-b) of the same size arranged directly adjoining one another in order completely to cover the bottom of the melting crucible (2, 4) or comprises a single monocrystalline seed crystal plate in which at least one dislocation line is formed, which divides the single monocrystalline seed crystal plate into seed crystal plate sub-portions (1a-31d; 36a-d; 36a-b) of the same size;

wherein the monocrystalline metal or semi-metal body (35) is divided by sawing along at least one sawing line (37, 38) extending in parallel with the crystal orientation into a plurality of monocrystalline metal or semi-metal bodies; and

the start of the respective sawing line (37, 38) is selected in such a way that said start is defined by the edge of a seed crystal plate (36a-d; 36a-b) or by a respective dislocation line within the single monocrystalline seed crystal plate;

wherein a heating device surrounding the melting crucible (2, 4) comprises a top heater (6), a bottom heater (5) and a flat heating device (7) surrounding side walls of the melting crucible (2, 4), wherein

the heat output of the flat heating device (7) decreases during the directional solidification from the upper end toward the lower end of the melting crucible (2, 4) in accordance with the temperature gradient at the center of the melting crucible; and

the flat heating device (7) comprises a plurality of heating elements (10-13) which in the longitudinal direction of the melting crucible (2, 4) or perpendicularly thereto have a meandering course and which are provided as webs (10-13) which extend perpendicularly to the longitudinal direction and the conductor cross sections of which increase from the upper end toward the lower end in a plurality of discrete steps;

wherein the melting crucible (2, 4) has a rectangular or square cross-section;

in corner regions of the crucible (2, 4) the heat output is higher or a distance between the crucible wall and the flat heating device (7) is smaller than in the other regions; and

the webs (10-13) are provided with a conductor cross-section which is constricted at regions of reversal (15-17) of the meandering course

2. The method as claimed in claim 1, wherein the respective seed crystal plate (31; 31a-31d; 36a-d; 36a-b) is cut from a monocrystalline metal or semi-metal body which was produced by directional solidification of a melt in a further melting crucible, wherein prior to the introduction of a semi-metal or metal raw material (32-34) or of the melt into the further melting crucible (2, 4) the bottom of the further melting crucible is completely covered with a thin monocrystalline seed crystal plate layer (31; 31a-31d; 36a-d; 36a-b) having a crystal orientation parallel to the vertical direction of the further melting crucible (2, 4); and

the temperature of the bottom of the further melting crucible (2, 4) is kept at a temperature below the melting temperature of the raw material (32-34) or of the melt in order to prevent melting of the seed crystal plate layer (31; 31a-31d; 36a-d; 36a-b) in any case down to the bottom of the melting crucible (2, 4); wherein

the thin monocrystalline seed crystal plate layer comprises a plurality of thin mono crystalline seed crystal plates (31 a-d; 31a-b) of the same size arranged directly adjoining one another in order completely to cover the bottom of the melting crucible (2, 4) or a single monocrystalline seed crystal plate in which at least one dislocation line is formed, which divides the single monocrystalline seed crystal plate into seed crystal plate sub-portions (31a-31d; 36a-d; 36a-b) of the same size.

3. The method as claimed in claim 2, wherein the temperature gradient during the directional solidification of the previous batch causes a planar, horizontal phase boundary between the liquid and solid state of the semi-metal or metal.

4. The method as claimed in claim 1, wherein at the start of the production of the seed crystal plate only a small central portion of the bottom of a further melting crucible (2, 4) is covered with a thin monocrystalline seed crystal plate (31a) having a crystal orientation parallel to the vertical direction of the melting crucible (2, 4) and the temperature gradient during the directional solidification of a melt in the further melting crucible causes a convex phase boundary between the liquid and solid state of the semi-metal or metal, so that the cross section of the monocrystalline metal or semi-metal body produced during the directional solidification increases in size in the direction toward the upper end of the further melting crucible, wherein the single monocrystalline seed crystal plate (31a) or the plurality of monocrystalline seed crystal plates are cut from the upper end or close to the upper end of the monocrystalline metal or semi-metal body thus produced.

5. The method as claimed in claim 1, wherein the respective seed crystal plate (31;31a-31d; 36a-d; 36a-b) is produced by
cutting at least two seed crystal plates (31a-31d; 36a-d; 36a-b) having a rectangular or square basic shape from a monocrystalline metal or semi-metal body produced by zone melting or by a Czochralski method,
completely covering the bottom of a further melting crucible with said at least two seed crystal plates having a crystal orientation in parallel with the vertical direction of the further melting crucible (2, 4), melting a semi-metal or metal raw material (32-34) in the further melting crucible to form a melt (3) or introducing a semi-metal melt or metal melt into the further melting crucible, directional solidification of the melt under the action of a temperature gradient pointing in the vertical direction and from the upper end of the further melting crucible (2, 4) to the lower end thereof to form a monocrystalline metal or semi-metal body, and cutting the respective seed crystal plate (31; 3la-31d; 36a-d; 36a-b) from the monocrystalline metal or semi-metal body thus directionally solidified, wherein

the temperature of the bottom of the further melting crucible (2, 4) is kept at a temperature below the melting temperature of the raw material (32-34) or of the melt in order to prevent melting of the seed crystal plate layer in any case down to the bottom of the further melting crucible (2, 4).

6. The method as claimed in any of claims 2 to 5, wherein furthermore the respective seed crystal plate (31; 31a-31d; 36a-d; 36a-b) is cut from the directionally solidified monocrystalline metal or semi-metal body by sawing in a direction perpendicular to the vertical direction.

7. The method as claimed in claim 6, wherein the respective seed crystal plate (31; 31a-31d; 36a-d; 36a-b) is further cut by sawing in a direction parallel to the vertical direction, wherein the start of the respective sawing line is selected in such a way that said start is defined either by the edge of a seed crystal plate (36a-d; 36a-b) or by a respective dislocation line within the single monocrystalline seed crystal plate.

8. The method as claimed in any of the preceding claims, wherein the direction of the temperature gradient is never reversed during the melting of the semi-metal or metal raw material in the melting crucible and during the directional solidification of the melt in the melting crucible.

9. The method as claimed in any of the preceding claims, wherein the semi-metal is silicon and the temperature of the bottom of the melting crucible is kept below 1,400 °C, more preferably below 1,380 °C.

10. The method as claimed in any of the preceding claims, wherein the melting crucible (2, 4) has a rectangular or square cross section.

11. The method as claimed in any of the preceding claims, wherein the webs (10-13) are provided at the reversal regions with a conductor cross-section which is constricted in the diagonal direction, so that the conductor cross-section is identical to the conductor cross-section of an associated web before or after the respective reversal region.

12. The method as claimed in claim 11, wherein the constrictions of the conductor cross-sections at the reversal regions (15-17) are formed by forming a plurality of perforations or recesses in or out of the web material, said plurality of perforations or recesses being distributed transversely to the conductor cross section.

13. The method as claimed in any of the preceding claims, wherein the semi-metal or metal raw material is lumpy, granular silicon which is melted on starting from the upper edge of the melting crucible, so that melted-on, liquid silicon runs or seeps downward through the silicon feedstock, wherein for replenishing the melting crucible, the raw material silicon granules (34), preferably of medium or fine grain size, is applied to the bottom being covered by the seed crystal plate layer (31; 31a-31d; 36a-d; 36a-b), there are introduced first the silicon granules (34) in a thin layer and subsequently large silicon plates (32) in the horizontal orientation, so that said plates each extend from the center of the melting crucible substantially up to the inner walls thereof, and/or are introduced in the vertical orientation, so that said plates extend substantially up to the upper edge of the melting crucible, the large silicon plates (32) are covered by further silicon granules (34), and the silicon feedstock is finally covered by smaller pieces of silicon (33).

**Revendications**

1. Un procédé de production d'un métal mono cristallin ou de corps semi-métallique par solidification directionnelle, dans lequel un semi-métal ou une matière première métallique (32-34) est mis en fusion au sein d'un creuset (2, 4) pour former une coulée (3) ou une coulée semi-métallique ou métallique est introduite dans le creuset, la coulée est solidifiée de manière directionnelle sous l'action d'un gradient de température suivant une direction verticale et à partir de l'extrémité supérieure du creuset (2, 4) jusqu'à son extrémité inférieure et en présence d'une limite horizontale d'une phase entre l'état liquide et l'état solide durant la solidification directionnelle vers le métal mono-cristallin ou le corps semi-métallique, préalablement à l'introduction de la matière première métallique ou semi-métallique (32 à 34) ou de la coulée au sein du creuset (2, 4), l'on couvre complètement le fond du creuset avec une fine couche plane cristalline de germe mono cristallin (31; 31a-31d; 36a-d; 36a-b), dont l'orientation cristalline est parallèle à la direction verticale du creuset (2, 4);

l'on maintient la température du fond du creuset (2, 4) à une température inférieure à la température de fusion de la matière première (32-34), ou de la coulée afin de prévenir, en toute situation, la fusion de la couche plane cristalline de germe (31; 31a-31d; 36a-d; 36a-b) au fond du creuset (2, 4) ; la méthode étant telle que :

la fine couche plane cristalline de germe mono cristallin (31 ad, 31 ab) comporte une pluralité de fine plaques cristallines d'un germe mono cristallin (31a-31d ; 31a-b) de dimension semblable et directement juxtaposées de manière à couvrir complètement le fond du creuset (2,4) ou comporte une seule plaque cristalline d'un germe mono cristallin dans laquelle est formée au moins une ligne de fracture, divisant la plaque cristalline de germe mono cristallin unique en sous parties (31a-31d ; 36a-d ; 36a-b) de même dimension ;

dans lequel le métal mono cristallin ou le corps semi-métallique (35) est divisé par découpage le long d'au moins une ligne de découpage (37, 38) s'étendant parallèlement à l'orientation cristalline en une pluralité de métaux mono cristallins ou de corps semi-métallique; et

le départ de la ligne de découpage respective (37, 38) est choisi de façon à correspondre au bord de la plaque cristalline de germe (36a-d ; 36a-b) ou grâce à une line de fracture respective au sein de l'unique plaque cristalline de germe mono cristalline ;

dans lequel un dispositif de chauffage entourant le creuset (2, 4) comporte un chauffage supérieur (6), un chauffage inférieur (5) et un dispositif de chauffage plat (7) entourant les parois latérales du creuset (2, 4), dans lequel

la sortie de chaleur du dispositif de chauffage plat (7) décroît durant la solidification directionnelle depuis l'extrémité supérieure vers l'extrémité inférieure du creuset (2, 4) suivant le gradient de température au centre du creuset ; et

le dispositif de chauffage plat (7) comporte une pluralité d'éléments chauffants (10-13) qui, suivant la direction longitudinale du creuset (2, 4) ou perpendiculairement, présente un tracé sinueux en bande continue (10-13) s'étendant perpendiculairement à la direction longitudinale et dont les sections en coupe conductrice augmentent par pas discrets depuis l'extrémité supérieure jusqu'à l'extrémité inférieure ;

dans lequel le creuset (2, 4) présent une section rectangulaire ou carrée ;

l'on dispose dans les régions d'angle du creuset (2, 4) une sortie calorifique plus importante ou une distance moindre entre les parois du creuset et le dispositif de chauffage plat (7) que dans les autres régions ; et

les bandes continues (10-13) sont fournies avec une section conductrice qui est contrainte dans les régions d'inversion (15-17) du tracé sinueux.

2. Le procédé selon la revendication 1, dans lequel la plaque cristalline de germe respective (31; 31a-31d; 36a-d; 36a-b) est découpée à partir d'un métal monocristallin ou d'un corps semi-métallique, qui a été produit par solidification dirigée d'une coulée au sein d'un autre creuset, dans lequel

préalablement à l'introduction d'une matière première métallique ou semi-métallique (32 à 34) ou de la coulée au sein du creuset (2, 4), l'on couvre complètement le fond du creuset au moyen d'une fine couche plane cristalline de germe mono cristallin (31; 31a-31d; 36a-d; 36a-b), dont l'orientation cristalline est parallèle à la direction verticale du creuset supplémentaire (2, 4); et

l'on maintient la température du fond du creuset supplémentaire (2, 4) à une température inférieure à la température de fusion de la matière première (32-34), ou de la coulée afin de prévenir, en toute situation, la fusion de la couche plane cristalline de germe (31; 31a-31d; 36a-d; 36a-b) au fond du creuset (2, 4) ; dans lequel:

la fine couche plane cristalline de germe mono cristallin (31 ad, 31 ab) comporte une pluralité de fine plaques cristallines d'un germe mono cristallin (31a-31d ; 31 a-b) de même dimension et directement juxtaposées de manière à couvrir complètement le fond du creuset (2,4) ou une plaque cristalline d'un germe mono cristallin unique dans laquelle est formée au moins une ligne de fracture, divisant la plaque cristalline de germe mono cristallin unique en sous parties (31a-31d ; 36a-d ; 36a-b) de même dimension.

3. Le procédé selon la revendication 2, dans lequel le gradient de température produit une limite de phase horizontale et plane entre l'état liquide et solide du matériau métallique ou semi-métallique lors de la solidification directionnelle du lot précédent.

4. Le procédé selon la revendication 1, dans lequel au début de la préparation de la plaque cristalline de germe, seule une petite partie centrale du fond d'un autre creuset (2, 4) est recouverte d'une d'une plaque cristalline de germe mono-cristallin (31a) ayant une orientation cristalline parallèle à la direction verticale du creuset (2,4) et le gradient de température provoque une limite de phase convexe entre l'état liquide et l'état solide du matériau semi-métallique ou métallique durant la solidification directionnelle d'une coulée au sein du creuset supplémentaire, en sorte que la section du matériau métallique mono cristallin ou du corps semi-métallique produit durant la solidification directionnelle s'accroît dans ses dimensions suivant la direction vers l'extrémité supérieure du creuset supplémentaire, dans lequel l'unique plaque cristalline de germe mono cristallin (31 a) ou la pluralité de plaques cristallines de germe mono cristallin est découpée à partir de l'extrémité supérieure ou proche de l'extrémité supérieure du matériau métallique mono cristallin ou du corps semi-métallique ainsi produit.

5. Le procédé selon la revendication 1, dans lequel la plaque cristalline de germe respective (31; 31a-31d) est produite par :

la découpe d'au moins deux plaques cristalline de semence (31a-31d; 36a-d; 36a-b) yanat une forme rectangulaire ou principalement carrée à partir d'un métal mono cristallin ou d'un corps semi métallique produit par fusion de zone ou grâce à une méthode Czochralski,
le recouvrement complet du fond d'un creuset supplémentaire avec au moins de plaques cristallines de semence ayant une orientation cristalline parallèle à la direction verticale du creuset supplémentaire (2, 4),
la fusion d'un matière première métallique ou semi-métallique (32-34) au sein du creuset supplémentaire pour former une coulée (3) ou l'introduction d'une coulée métallique ou semi-métallique au sein du creuset supplémentaire,
la solidification directionnelle de la coulée sous l'action d'un gradient de température pointant suivant une direction verticale depuis l'extrémité supérieure du creuset supplémentaire (2, 4) vers son extrémité inférieure pour former un métal mono cristallin ou un corps semi-métallique, et
la découpe de la plaque cristalline de germe respective (31; 31a-31d; 36a-d; 36a-b) à partir du métal mono cristallin ou du corps semi métallique ainsi solidifié de manière directionnelle, dans lequel
la température du fond du creuset supplémentaire (2, 4) est maintenue à une température inférieure à la température de fusion de la matière première (32-34), ou de la coulée afin de prévenir, en toute circonstance, la fusion de la couche cristalline plane de germe au fond du creuset supplémentaire (2, 4).

6. Le procédé selon l'une des revendications 2 à 5, dans lequel la plaque respective de germe cristallin (31; 31a-31d; 36a-d; 36a-b) est découpée depuis le métal mono cristallin ou du corps semi-métallique solidifiée de manière directionnelle suivant une direction perpendiculaire à la direction verticale.

7. Le procédé selon la revendication 6, dans lequel la plaque cristalline de germe respective (31; 31a-31d; 36a-d; 36a-b) est en outre séparée par découpée suivant une direction parallèle à la direction verticale, dans lequel le départ de la ligne respective de découpe est choisi de façon à correspondre soit au bord d'une plaque cristalline de germe (36a-d 36a-b) ou à une ligne de fracture respective au sein de l'unique plaque cristalline de germe mono cristallin.

8. Le procédé selon l'une quelconque des revendications précédentes, dans lequel la direction du gradient de température au sein du creuset n'est jamais inversée durant la fusion au sein du creuset du matériau métallique ou semi-métallique et durant la solidification directionnelle de la coulée au sein du creuset.

9. Le procédé selon l'une quelconque des revendications précédentes, dans lequel le matériau semi métallique est du silicium et la température du fond du creuset est maintenue inférieure à 1400 °C, et de préférence sous la valeur de 1380°C.

10. Le procédé selon l'une quelconque des revendications précédentes, dans lequel le creuset (2, 4) présente une section transversale rectangulaire ou carrée.

11. Le procédé selon l'une quelconque des revendications précédentes, dans lequel les bandes (10-13) sont prévues au niveau des régions d'inversion avec une section conductrice se rétrécissant suivant la direction diagonale, en sorte que la section conductrice est identique à celle d'une bande associée avant ou après la région d'inversion respective.

12. Le procédé selon la revendication 11, dans lequel les rétrécissements de la section transversale du conducteur au niveau des zones d'inversion (15-17) sont formés par une pluralité de perforations ou d'évidements dans ou sur le matériau en bande, ladite pluralité de perforations ou d'évidemment étant distribuée transversalement à la section conductrice..

13. Le procédé selon l'une quelconque des revendications précédentes, dans lequel le semi-métal ou de matière première métallique est du silicium granulaire qui est fondu à partir du bord supérieur du creuset, en sorte que, une fois fondu, le silicium liquide passant au travers la masse de silicium, dans lequel pour remplir le creuset, la matière première sous forme de granulés de silicium (34), de préférence de grain fin ou moyen, est appliquée au fond recouvert par la couche plane cristallin de semence (31; 31a-31d; 36a-d; 36a-b),

l'on introduit d'abord les granulés de silicium (34) au sein d'une couche mince et, successivement des larges plaques de silicium (32) suivant une disposition horizontale, de telle manière que les plaques s'étendent depuis le centre du creuset jusqu'à ses parois intérieures, et/ou sont introduites verticalement, de telle manière que lesdites plaques s'étendent significativement vers l'extrémité supérieure du creuset, l'on recouvre les plaques larges de silicium (32) par de nouveaux granulés de silicium (34), et

l'on recouvre finalement la masse de silicium par de plus petites parties de silicium (33).

Fig. 1

EP 2 028 292 B1

Fig. 2a

33

33

2

31a    31b    31c    31d

Fig. 2b

Fig. 2c

Fig. 2d

Fig. 3a

Fig. 3b

35

37

36a

36b

Fig. 3c

35

37

36a

36b

Fig. 3d

Fig. 4

Fig. 5

EP 2 028 292 B1

Fig. 6a          Fig. 6b          Fig. 6c

EP 2 028 292 B1

Fig. 7a   Fig. 7b   Fig. 7c

10

100    102    101

104

Fig. 7d

EP 2 028 292 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4256530 A
- EP 0631832 A
- EP 0996516 A
- DE 19855061
- EP 0218088 A1
- EP 1162290 A1
- DE 102006017622
- DE 102006017621

- US 4404172 A
- EP 0372794 B1
- DD 298532 A5
- US 4381214 A
- WO 2007084934 A2
- US 20070169684 A1
- EP 0887442 A1
- EP 0748884 A1

**In der Beschreibung aufgeführte Nicht-Patentliteratur**

- **N. STODDARD et al.** Casting Single Crystal Silicon: Novel Defect Profiles from BP Solar's Mono2 ™ Wafers. *Solid State Phenomena,* 2008, vol. 131-133, 1-8

- *PATENT ABSTRACTS OF JAPAN,* 10-194718
- *PATENT ABSTRACTS OF JAPAN,* 2007-022815